# EUROPÄISCHE PATENTSCHRIFT

(11) **EP 3 080 192 B1**
(45) Veröffentlichungstag und Bekanntmachung des Hinweises auf die Patenterteilung: **20.09.2023**
(21) Anmeldenummer: 14830938.8
(22) Anmeldetag: 26.11.2014
(51) Int. Cl.: C08G 77/60, C09D 183/16, C08G 77/06, C23C 18/12, C08G 77/12

(54) **VERFAHREN ZUR POLYMERISATION EINER ZUSAMMENSETZUNG ENTHALTEND HYDRIDOSILANE UND ANSCHLIESSENDEN VERWENDUNG DER POLYMERISATE ZUR HERSTELLUNG VON SILICIUMHALTIGEN SCHICHTEN**
METHOD FOR THE POLYMERIZATION OF A COMPOSITION CONTAINING HYDRIDOSILANES AND FOR THE SUBSEQUENT USE OF THE POLYMERS TO PRODUCE LAYERS CONTAINING SILICON
PROCÉDÉ DE POLYMÉRISATION D'UNE COMPOSITION CONTENANT DES HYDRUROSILANES ET UTILISATION SUBSÉQUENTE DES POLYMÉRISATS POUR LA PRODUCTION DE COUCHES CONTENANT DU SILICIUM

(30) Priorität: 11.12.2013 DE 102013020518
(43) Veröffentlichungstag der Anmeldung: 19.10.2016
(73) Patentinhaber: Forschungszentrum Jülich GmbH, 52425 Jülich (DE)
(72) Erfinder: CADIZ BEDINI, Andrew Paolo, 72764 Reutlingen (DE)
(86) Internationale Anmeldenummer: PCT/DE2014/000617
(87) Internationale Veröffentlichungsnummer: WO 2015/085980

(56) Entgegenhaltungen:
- EP-A1- 1 087 428
- WO-A1-2011/104147
- WO-A2-2011/061106
- DE-A1-102010 041 842

## Beschreibung

Die Erfindung betrifft ein Verfahren zur Polymerisation einer Zusammensetzung enthaltend Hydridosilane und anschließenden Verwendung der Polymerisate zur Herstellung von siliziumhaltigen Schichten. Ferner betrifft die Erfindung durch das Verfahren hergestellte Nanopartikel enthaltende Schichten sowie ihre Verwendung zur Herstellung von halbleitenden oder isolierenden Dünnschichten mit darin eingebetteten Nanopartikeln,

### Stand der Technik

Bei der Herstellung von Solarzellen werden Halbleiterschichten mit unterschiedlicher Dotierung benötigt, die zumindest einen Schottky- oder p-n-Übergang aufweisen. Wie nach dem Stand der Technik bekannt [WO 2011/061106 A2], kann durch Abscheiden einer amorphen Schichtfolge aus einer flüssigen Phase, enthaltend unter anderem höhere Silane, auf einem geeigneten Substrat ein p-i-n-Übergang erzeugt werden, der mit geeignetem Front- und Rückkontakt als Solarzelle wirkt. Bei der Herstellung von Dünnschichtsolarzellen, die auf p-i-n-Übergängen basiert sind, erfolgt eine Dotierung der einzelnen Dotierschichten als n-Siliziumschicht mit z.B. einer geeigneten Phosphorverbindung wie weißem Phosphor, als p-Siliziumschicht mit z.B. einer geeigneten Borverbindung wie Decaboran, wobei die geeigneten Phosphor- oder Borverbindungen den Flüssigphasen zugesetzt werden. Diese können selbst flüssig sein oder sich in der flüssigen Phase lösen. Im Falle der Herstellung einer intrinsischen (i-), d.h. undotierten Siliziumschicht, werden keine zusätzlichen Dotierstoffe zugesetzt.

Zur Herstellung siliziumhaltiger Schichten auf Basis von Flüssigsilan werden im Allgemeinen Zusammensetzungen enthaltend unter anderem Hydridosilane eingesetzt. Diese Zusammensetzungen werden vor ihrer Aufbringung auf das jeweilige Substrat zunächst zu höheren Hydridosilanen polymerisiert.

Allgemein wird eine Polymerisation mittels elektromagnetischer Strahlung (wie z.B. mittels ultraviolettem (UV) Licht) oder Wärmezufuhr als eine ringöffnende Polymerisation bezeichnet, wenn das Edukt aus zyklischen Monomeren, z.B. Cyclopentasilan (Si₅H₁₀) oder Cyclohexasilan (Si₆H₁₂), besteht. Diese werden mittels der Wirkung von Licht bzw. Wärme aufgespalten und alleine oder durch weitere Anbindung von anderen Hydridosilanen zu linearen und/oder verzweigten Polymerketten aus Silizium und Wasserstoff umgesetzt. Die resultierenden Hydridosilane werden mit der allgemeinen Formel -(SiH₂)ₙ- gekennzeichnet und werden auch als Poly- oder Oligosilane bezeichnet. Hydridosilane mit einer molaren Masse kleiner als ca. 302 g/mol (d.h. ≤ 10 Si-Atome) werden als "niedere Hydridosilane" und die mit . größeren molaren Massen als "höhere Hydridosilane" eingeordnet. Flüssig vorliegende Hydridosilane werden auch als Flüssigsilan bezeichnet.

Silizium-Dünnschichten auf Basis von Flüssigsilan werden normalerweise mittels Rotationsbeschichtung auf ein Substrat aufgebracht. Dafür ist es üblich, das Flüssigsilan in einem Lösungsmittel zu verdünnen. Diese Lösung wird anschließend polymerisiert. Im Falle von zyklischen Edukten kann die Lösung mit UV-Licht bestrahlt werden, um die Photopolymerisation des gelösten Flüssigsilans zu ermöglichen. Anschließend wird die photopolymerisierte Lösung filtriert, um unlösliche Hydridosilane aus der Lösung zu entfernen bzw. die molare Masse der photopolymerisierten Hydridosilane zu kontrollieren. Die filtrierte Lösung wird anschließend mittels Rotationsbeschichtung auf das Substrat aufgebracht. Abschließend erfolgt ein Aufheizen der Schicht, um das Lösungsmittel zu verdampfen und das Silizium in eine amorphe Form umzuwandeln. Letzteres wird Konvertierung genannt. Alternativ zum direkten nasschemischen Verfahren kann auch ein Trägergas, z.B. Wasserstoff, durch das Flüssigsilan geleitet werden (Bubbler-System). Diese Gasmischung wird abschließend mittels PECVD (Plasma Enhanced Chemical Vapor Deposition) oder HWCVD (Hot Wire Chemical Vapor Deposition) zersetzt und auf das Substrat abgeschieden.

Die erhaltenen Siliziumschichten können eine Mischung von mikrokristallinen, polykristallinen und amorphen Strukturen aufweisen, abhängig davon, unter welchen Bedingungen (z.B. Prozesstemperatur, Aufheizdauer, Wasserstoffpartialdruck) die Konvertierung stattfindet. Die Kristallinität der Schicht, die sich üblicherweise in amorphem Zustand befindet, kann anschließend beispielsweise mittels Laserbestrahlung [1] oder thermischer Behandlung (z.B. T höher als 600° C) erhöht werden.

Die nach dem Stand der Technik bekannten photochemischen Verfahren zur Herstellung von Beschichtungslösungen (Precursoren) für Siliziumschichten sind nachteilig sehr zeit- und arbeitsaufwendig. Die Photopolymerisation ist ein sehr zeitaufwendiges Verfahren. Bestrahlungen dauern typischerweise zwischen 10 und 120 Minuten [2] [3] oder bis zu 840 Minuten [DE 10 2010 041 842 A1] und durch die Verwendung von UV-Bestrahlung entstehen zusätzliche Beschaffungskosten und eventuell müssen Sicherheitsmaßnahmen getroffen werden.

In [WO 2012/084261 A1] wird ein anderes Verfahren beschrieben, siliziumhaltige Schichten auf ein Substrat abzuscheiden, bei dem ein fokussierter Strahl geladener Teilchen (Ionen oder ein Elektronenstrahl) verwendet wird, um einen Polysilan-basierten Precursor direkt auf einem Substrat zu dissoziieren. Bei der Herstellung von Siliziumschichten für optoelektronische Anwendungen weist das Verfahren Nachteile auf, da teure Vakuumtechnik und ein modifiziertes Rasterelektronmikroskop (REM) verwendet werden müssen. Alternativ zur Verwendung von einem Elektronenstrahl, können stattdessen Ga⁺-lonen eingesetzt werden. Hier weist das Verfahren den Nachteil auf, dass die Herstellung von intrinsischen Siliziumschichten aufgrund der Dotierungseigenschaft von Ga erschwert wird.

Hydridosilane können auch mittels thermischer Verfahren zur Polymerisation gebracht werden [DE 10 2010 041 842 A1]. Hier werden beispielsweise Reaktionsgemische aus unter anderem Neopentasilan Si(SiH₃)₄ bei 154°C aufgeheizt und für ungefähr 200 bis 480 Minuten thermisch behandelt.

Die Polymerisation mittels Wärmezufuhr wird dadurch realisiert, dass Si-Si und/oder Si-H Bindungen der zyklischen bzw. linearen oder verzweigten Monomere thermisch aufgespalten werden. Anschließend erfolgt durch Kettenbildung die Entstehung von höheren Hydridosilanen. Hierfür ist es notwendig, reines Flüssigsilan oder ein verdünntes Flüssigsilan in Form einer Hydridosilanlösung (= Hydridosilane in einem Lösungsmittel verdünnt), auf hohe Temperaturen bis zu 235°C [WO 2011/104147 A1] zu erhitzen, um die thermische Zersetzung auszuführen. Diese Methode hat den Nachteil, dass sie energieintensiv ist und dass Aufgrund des Aufwärmvorgangs bzw. der thermischen Restenergie der Lösung, die Polymerisation ohne zusätzliche Arbeitsschritte nicht sofort initiiert (auf Grund des Aufheizvorgangs) bzw. (auf Grund des Abkühlvorgangs) nicht sofort abgebrochen werden kann.

Nachteil aller zuvor genannten Methoden zur Herstellung von Beschichtungslösungen für Siliziumschichten, sind die zeitaufwändigen Temperatur- und UV-Bestrahlungs- bzw. Filtrierungsschritte, die für die Polymerisation bzw. Molekulargewichtsbegrenzung notwendig sind. Ferner findet beim Aufbringen der Hydridosilane auf das Substrat mittels Rotationsbeschichtung nachteilig eine Verschwendung von wertvollem Material statt, da die Lösung in Folge der Rotation nicht nur auf die Substratoberfläche verteilt wird, sondern durch die Zentrifugalkraft zu schätzungsweise über 90 % über die zu beschichtende Fläche hinaus weggeschleudert wird. Darüber hinaus weisen durch Rotationsbeschichtung hergestellte dünne Schichten eine inhomogene Bedeckung des Substrats auf, wobei nur ebene, feste Substrate verwendet werden können. Bei der Beschichtung mit ultradünnen Schichten (< 2 nm) oder bei Schichtwachstum in Form von Monolagenbeschichtung, ist Rotationsbeschichtung als Methode wegen auf dieser Skala signifikanten Oberflächenrauheiten und -welligkeiten von z.B. > 3 nm [WO 2011/104147 A1] wenig geeignet. Beim Dispergieren von Nanopartikeln in entweder einem Lösungsmittel (z.B. Cyclooctan, Ethanol, Toluol, Wasser), in einer Hydridosilanlösung oder direkt im reinen flüssigen Hydridosilan (sowohl im monomeren als auch im polymeren Hydridosilan), weisen die anschließend mittels Rotationsbeschichtung hergestellten Schichten, sowohl eine suboptimale Nanopartikeleinbettung, als auch eine suboptimale Nanopartikelverteilung auf. Bei der Beschichtung von strukturierten Oberflächen mit Nanopartikeln weisen mittels Rotationsbeschichtung erzielte Bedeckungen eine geringe Qualität mit beispielsweise einer inhomogenen Nanopartikelverteilung und einer geringen Reproduzierbarkeit auf. Derart strukturierte Oberflächen werden in der Photovoltaik beispielsweise für Light-Trapping-Zwecke und als plasmonische Reflexionsgitter verwendet, um den Wirkungsgrad von Solarzellen zu erhöhen.

Aus dem Stand der Technik sind die Anwendung und der Einfluss von Ultraschallwellen und akustischer Kavitation auf chemische und physikalische Vorgänge bekannt. Der Ultraschall dient dazu, akustische Kavitation, d.h. Bildung, Wachstum und Implosion von Mikrokavitäten in den Flüssigkeiten auszulösen. Der in den Mikrokavitäten vorherrschende Druck und die effektive Temperatur liegen im Bereich von 1000 bar bzw. 5000°C [4]. Die Prozesstemperatur, d.h. die Temperatur, die in der Flüssigkeit oder im Reaktionsgefäß selbst vorherrscht, kann dabei jedoch beispielsweise bei Temperaturen unter 0°C bzw. bei Raumtemperatur bzw. im Bereich unter 150°C bleiben, abhängig davon, welche Anwendung jeweils beabsichtigt oder Vorrichtung verwendet wird. Ultraschallwellen können bei der Behandlung von Lösungen und Gegenständen verwendet werden, um rein physikalische Effekte, wie z.B. Deagglomerierung und Dispergierung von Partikeln, Emulsionsbildung oder Ultraschallreinigung zu ermöglichen. Die chemischen Effekte beruhen auf in Mikrokavitäten und ihrer unmittelbaren Nähe ausgelösten Phänomenen wie Bindungsspaltung durch Zugkräfte oder hohe transiente Temperaturen und Radikalerzeugung. Die Anwendung von Ultraschall stellt eine Alternative zur klassischen Photo-, Thermo- oder katalytischen Chemie dar. Allgemein ist die mittels akustischer Kavitation unterstütze Chemie als "Sonochemie" bekannt und weist unzählige Anwendungen wie z.B. Degradation von organischen Polymeren, Polymerisation von organischen Verbindungen, Erzeugung von Radikalen, Beschleunigung von chemischen Reaktionen, usw. auf.

### Aufgabe und Lösung

Die Aufgabe der Erfindung ist es, ein Verfahren zur Polymerisation einer Zusammensetzung enthaltend Hydridosilane und anschließenden Verwendung der Polymerisate zur Herstellung von siliziumhaltigen Schichten bereitzustellen, welches ein gegenüber dem Stand der Technik einfacheres und schnelleres Verfahren zur Herstellung von siliziumhaltigen Schichten zulässt, als es bislang nach dem Stand der Technik möglich ist.

Ferner ist es die Aufgabe der Erfindung, mit diesem Verfahren hergestellte Nanopartikel enthaltende Siliziumschichten bereitzustellen. Die Erfindung betrifft weiterhin die Verwendung dieser siliziumhaltigen Schichten zur Herstellung von halbleitenden oder isolierenden Dünnschichten mit darin eingebetteten Nanopartikeln.

Schichten, die mit der vorliegenden Erfindung hergestellt werden, können höherwertige strukturelle und elektronische Eigenschaften aufweisen. Mit der Deposition mittels Aerosolbeschichtung können sowohl gegenüber bisher bekannten Verfahren vergleichbare oder niedrigere Oberflächenrauheiten und -welligkeiten, als auch eine homogenere Bedeckung des Substrats erzielt werden.

Wird erfindungsgemäß ein gleichzeitiges periodisches Aufheizen des Substrats und eine kontinuierliche Aerosolzufuhr während der Beschichtung durchgeführt, so wird der in unmittelbarer Nähe des Substrats wachsende amorphe Film vor dem Einfluss der in der Regel vorhandenen Verunreinigungen in der Stickstoffatmosphäre während der Beschichtung komplett oder teilweise geschützt. Die durch das erfindungsgemäße Verfahren hergestellten Schichten können beispielsweise in Solarzellen, Fotodioden oder Dünnschicht-Transistoren eingesetzt werden.

Die Aufgaben der Erfindung werden gelöst durch ein Verfahren mit den Kennzeichen gemäß Hauptanspruch, sowie durch eine Siliziumschicht sowie deren Verwendung mit den Merkmalen gemäß Nebenansprüchen. Vorteilhafte Ausführungsformen des Verfahrens und der Siliziumschicht sind den jeweils darauf rückbezogenen Ansprüchen zu entnehmen.

### Gegenstand der Erfindung

Gegenstand der Erfindung ist ein Verfahren zur Polymerisation einer Zusammensetzung enthaltend Hydridosilane und anschließenden Verwendung der Polymerisate zur Herstellung von siliziumhaltigen Schichten umfassend folgende Schritte:
a) Bereitstellung eines Substrats.
b) Bereitstellung einer Zusammensetzung enthaltend wenigstens ein Hydridosilan, das entweder in mindestens einem organischen und/oder anorganischen Lösungsmittel gelöst ist (im Folgenden auch als Hydridosilanlösung bezeichnet) oder enthaltend wenigstens ein Hydridosilan, das auch ohne Lösungsmittel bereits flüssig vorliegt (synonym auch als Flüssigsilan oder reines flüssiges Hydridosilan bezeichnet), wobei die zuvor genannten Hydridosilane wenigstens ein lineares und/oder verzweigtes Hydridosilan der allgemeinen Formel SiₙH₂ₙ+₂ mit n ≥ 3 und/oder ein zyklisches Hydridosilan der allgemeinen Formel SiₙH₂ₙ mit n ≥ 3 umfassen.
c) Polymerisation der Zusammensetzung aus Schritt b) mittels akustischer Kavitation.
d) Beschichtung der Oberfläche des Substrats mit Reaktionsprodukten aus Schritt c).

Die zu polymerisierenden Hydridosilane können wenigstens ein lineares und/oder verzweigtes Hydridosilan der allgemeinen Formel SiₙH₂ₙ+₂ mit n ≥ 3 und/oder ein zyklisches Hydridosilan der allgemeinen Formel SiₙH₂ₙ mit n = 3 bis 15 umfassen.

Die Zusammensetzung gemäß Schritt b) kann wenigstens ein "niederes" Hydridosilan mit ≤ 10 Si-Atomen mit einer molaren Masse zwischen 90 bis 305 g/mol enthalten. Sie kann insbesondere wenigstens ein Hydridosilan aus der Gruppe Trisilan, Tetrasilan, Pentasilan, Hexasilan, Heptasilan, Cyclopentasilan, Cyclohexasilan oder Neopentasilan, enthalten.

In einer vorteilhaften Ausführung des Verfahrens kann der Zusammensetzung gemäß Schritt b) wenigstens auch Mono- und/oder Disilan- und/oder ein Borhaltiger Dotierstoff und/oder Phosphorhaltiger Dotierstoff und/oder Edelgas aus der Gruppe Ar, He und/oder Nanopartikel und/oder ein Polymerisationsinitiator und/oder ein Katalysator und/oder oberflächenspannungsmodifizierende Mittel zugesetzt werden.

Die polymerisierte Hydridosilanlösung oder das polymerisierte reine flüssige Hydridosilan kann bevorzugt Hydridosilane mit einer molaren Masse zwischen ca. 92 und 1·10⁶ g/mol enthalten.

In einer vorteilhaften Ausführung des Verfahrens wird mindestens ein organisches und/oder anorganisches Lösungsmittel eingesetzt. Dies kann beispielsweise Cyclooctan, Ethanol, Toluol oder Wasser umfassen. Aber auch alle gemäß Stand der Technik weiteren bekannten organischen und/oder anorganischen Lösungsmittel können verwendet werden.

Die Konzentration der Hydridosilane im Lösungsmittel kann zwischen 0 bis ≤ 100 Gew.% betragen. Die eingestellte Konzentration der Hydridosilane ist abhängig davon, welche Polymerisationsgeschwindigkeit, welcher Gehalt an Hydridosilanen im Aerosol bzw. welche Wachstumsrate der Siliciumschicht gewünscht ist.

Bei einer 0 Gew.-%igen Silankonzentration liegt ein Lösungsmittel ohne Hydridosilane, aber mit eingemischten Nanopartikeln vor. Bei einer 100 Gew.-%igen Hydridosilan-Konzentration liegt reines flüssiges Hydridosilan (= Flüssigsilan) vor oder Flüssigsilan, dem Nanopartikel zugesetzt wurden. Weiterhin kann die Zusammensetzung gemäß Schritt b) eine Hydridosilanlösung, umfassend wenigstens ein lineares oder verzweigtes Hydridosilan der allgemeinen Formel SiₙH₂ₙ+₂ mit n ≥ 3 und/oder ein zyklisches Hydridosilan der allgemeinen Formel SiₙH₂ₙ mit n ≥ 3, das in mindestens einem Lösungsmittel gelöst ist, umfassen, der Nanopartikel zugesetzt werden. In der Regel werden Nanopartikel in Konzentrationen von < 0,1 Gew. % zugesetzt.

Bei Verwendung einer 0 Gew.-%igen Silankonzentration kann zur anschließenden Herstellung der siliziumhaltigen Schicht beispielsweise eine zusätzliche siliziumhaltige Lösung zur Beschichtung des Substrats eingesetzt werden oder das benötigte Silizium in anderer Weise auf das Substrat aufgebracht werden.

Reaktionsprodukte aus Schritt c) können in einer vorteilhaften Ausführung des Verfahrens mittels akustischer Kavitation und/oder Kapillarwellen in Aerosole umgesetzt werden und diese zur Beschichtung gemäß Schritt d) mit der Oberfläche des Substrats in Kontakt gebracht werden.

Die akustische Kavitation zur Polymerisation bzw. auch Kapillarwellenbildung zur Aerosolbildung kann mit Hilfe einer magnetostriktiven oder piezoelektrischen Ultraschallquelle und/oder eines flüssigkeitsbetriebenen oder gasbetriebenen Schallwandlers erzeugt werden. Beispielhaft können hier Sonotroden oder Piezokeramiken als Ultraschallquellen genannt werden.

Dazu kann beispielsweise die Ultraschallquelle und/oder der Schallwandler zur Polymerisation, gemäß Schritt c) oder zur Aerosolbildung, in direktem Kontakt mit der Zusammensetzung aus Schritt b) gebracht werden oder über eine Zwischenflüssigkeit (Intermedium) mit der Zusammensetzung aus Schritt b) in Kontakt gebracht werden. Bei der Verwendung eines Intermediums kann beispielsweise ein kleines Flüssigkeitsvolumen der zu polymerisierenden Zusammensetzung in einem kleineren Reaktionsbehälter in einen größeren Behälter mit dem Intermedium getaucht werden, so dass die Ultraschallwellen der Piezokeramik bzw. Sonotrode über das Intermedium auf die Flüssigkeit in dem kleineren Reaktionsbehälter übertragen werden. Das Intermedium kann als Füllvolumen und/oder Kühlmittel dienen, welches für die Übertragung der Ultraschallwellen bzw. zur Wärmeabfuhr benötigt wird. Das Flüssigkeitsvolumen der zu polymerisierenden Zusammensetzung kann dadurch reduziert werden, was insbesondere bei Verwendung von teuren Edukten vorteilhaft ist. Das Intermedium sollte in der Regel eine Flüssigkeit sein. Die Ultraschallwellen der Piezokeramik können über das Intermedium auf einen Brennpunkt im Reaktionsbehälter fokussiert werden.

Die Spitze der Sonotrode oder die Piezokeramik sollte bevorzugt unterhalb der Flüssigkeitsoberfläche der Zusammensetzung aus Schritt b) oder des Intermediums angeordnet werden. Zur Polymerisation gemäß Schritt c) kann die Sonotrode entweder von unten oder von oben in die Zusammensetzung oder das Intermedium eingeführt werden.

Unter der Bezeichnung Polymerisation sollen im Rahmen der vorliegenden Erfindung Synthesereaktionen verstanden werden, die gleichartige oder unterschiedliche Monomere in Oligomere oder Polymere überführen. Obwohl in manchen Fällen die Kettenbildungsprozesse eher in einer Oligomerisierung erfolgen, findet bei längeren Behandlungsdauern und/oder bei Verwendung von Edukten mit niedrigen Molmassen eher eine Polymerisierung statt. Folglich wird im Zusammenhang mit dem erfindungsgemäßen Verfahren die Verknüpfung von verschiedenen Edukten als eine Polymerisation bezeichnet. Unter Polymerisation sollen Additionspolymerisationen (als Ketten- und/oder Stufenreaktion), Kondensationspolymerisationen, ringöffnende Polymerisationen, Copolymerisationen und Depolymerisationen verstanden werden. Diese Reaktionen finden in den Mikrokavitäten und deren unmittelbarer Hochtemperatur-, Hochdruckumgebung statt bzw. werden ausgelöst durch Reaktionen von mittels akustischer Kavitation erzeugten Radikalen im Flüssigkeitsvolumen. Die Aerosolbildung kann im selben erfindungsgemäßen Reaktionsbehälter oder in einem zusätzlichen Reaktionsbehälter, der auch als Aerosolierungszelle bezeichnet werden kann, stattfinden.

Im Rahmen der vorliegenden Erfindung wird unter dem Begriff "Aerosol" oder "Aerosoltröpfchen" flüssige Aerosolteilchen mit eingelösten niederen und höheren Hydridosilanen bzw. Nanopartikeln oder in N₂ suspendierte Kolloide aus niederen und höheren Hydridosilanen bzw. Nanopartikeln verstanden.

Die Reaktionsgeschwindigkeit der Polymerisation und der Aerosolbildung kann beispielsweise mit der Konzentration der dazugegebenen Nanopartikel und/oder Konzentration der Hydridosilane im Lösungsmittel gezielt gesteuert werden. Im Allgemeinen kann davon ausgegangen werden, dass mit steigender Konzentration der Nanopartikel bzw. mit steigender Konzentration der Hydridosilane, auch die Geschwindigkeit der Polymerisationsreaktionen zunimmt.

Die Temperatur der Zusammensetzung sowie die Polymerisations- und Aerosolbildungsrate können sowohl über den Betriebsmodus (z.B. kontinuierlicher oder gepulster . Modus) der Ultraschallquelle als auch über eine Abkühlvorrichtung festgestellt bzw. variiert werden. Besonders vorteilhaft ist es, dass die Polymerisation direkt mit Ausschalten/Einschalten der Ultraschallquelle abgebrochen/fortgesetzt werden kann.

Hinsichtlich des Temperatureinflusses kann im Allgemeinen davon ausgegangen werden, dass mit steigender Temperatur, der Dampfdruck des Lösungsmittels oder der Hydridosilane in den Mikrokavitäten steigen wird und damit das Abdämpfen der Implosionen der Mikrokavitäten ebenfalls ansteigen wird und folglich die sonochemikalischen Effekte abgeschwächt werden.

Die Polymerisation gemäß Schritt c) der Zusammensetzung und die Umsetzung der Reaktionsprodukte aus Schritt c) in Aerosole kann bevorzugt ab dem Gefrierpunkt des jeweils eingesetzten Lösungsmittels und/oder der Hydridosilane bis zur jeweiligen Grenze, ab der eine reine thermische Umsetzung der Edukte oder im Falle der Verwendung eines offenen Reaktionsbehälters, ein Abdampfen der Zusammensetzung stattfindet, durchgeführt werden. Das vorliegende Verfahren basiert weder auf einer photolytischen, noch einer thermischen Behandlung, sondern beruht auf den zuvor erwähnten chemischen und physikalischen Effekten der akustischen Kavitation.

Dabei kann die Polymerisation und/oder Aerosolbildung bei Temperaturen zwischen -70°C und 155°C durchgeführt werden. Bevorzugt kann im Temperaturbereich von ca. -55°C bis 150°C gearbeitet werden, wobei die Aerosolbildung bevorzugt bei Raumtemperatur bis zu ca. 30°C durchgeführt werden kann.

Die Ultraschallquelle oder der Schallwandler für die Erzeugung akustischer Kavitation kann im gepulsten Betrieb oder im kontinuierlichen Betrieb unter Durchflusskühlung der Reaktionsbehälter eingesetzt werden. Dadurch kann die Temperatur der Flüssigkeit im Reaktionsbehälter über den jeweiligen Arbeitszyklus der Ultraschallquelle/des Schallwandlers, auch als gepulster Arbeitszyklus bezeichnet, oder über die Durchflusskühlung, so eingestellt werden, dass die Hydridosilanlösung bzw. das reine flüssige Hydridosilan bzw. die Lösung, die mit gasförmigem Silan versetzt wird, durch die Energiezufuhr der akustischen Kavitation und Ultraschallwellen und im Falle einer Sonotrode und/oder Piezokeramik durch Wärmeerzeugung an der Ultraschallquelle/Flüssigkeit-Grenzfläche, nicht übererwärmt wird. So kann verhindert werden, dass Bestandteile der Lösung in einen gasförmigen Aggregatzustand übergehen. Bei einer Temperatur von ca. 111 °C würde beispielsweise das Lösungsmittel Toluol verdampfen und dadurch die Bearbeitung der Lösung erschwert werden. Typische Prozesstemperaturen liegen jedoch unterhalb von 75°C.

Die Polymerisation kann mit einer akustischen Behandlungsdauer (synonym auch als Beschallungsdauer bezeichnet) zwischen 1 Mikrosekunde und 15 Stunden durchgeführt werden. Bevorzugt sind Beschallungsdauern zwischen 0,05 und 12 Stunden. Es kann beispielsweise jedoch auch schon eine Beschallungsdauer ab einigen Mikrosekunden bis Millisekunden ausreichend sein. Als kleinste Beschallungsdauer kann auch die mit der jeweils eingesetzten Ultraschallquelle/dem Schallwandler technisch kleinstmöglich einstellbare Beschallungsdauer eingesetzt werden.

Die Produktbildung der Polymerisation kann mittels NMR (Nuclear Magnetic Resonance), massenspektrometrischer und/oder chromatographischer Verfahren überwacht werden und daraus resultierend kann die Temperatur der Flüssigkeit im Reaktor mit Hilfe der Durchflusskühlung oder durch Veränderung des Arbeitszyklus der eingebrachten akustischen Kavitationsenergie verringert werden, sobald beispielsweise durch das massenspektrometrische Verfahren eine erhöhte Konzentration von Reaktionsprodukten wie z.B. Pentasilan (Si₅H₁₂) ermittelt werden.

Das Verfahren kann sowohl in einem, als auch in zwei Reaktionsbehältern durchgeführt werden. Bei dem Einsatz von zwei Reaktionsbehältern, wird im ersten Reaktionsbehälter (= Polymerisierungszelle) die Polymerisation mittels akustischer Kavitation gemäß Schritt c) durchgeführt und in dem weiteren Reaktionsbehälter (= Aerosolierungszelle) die Aerosolbildung mittels akustischer Kavitation und/oder Kapillarwellen durchgeführt. Die Reaktionsprodukte der Polymerisation können dann aus dem ersten Reaktionsbehälter in den zweiten Reaktionsbehälter zur Aerosolbildung überführt werden. Dies kann beispielsweise durch eine Verbindungsleitung zwischen den beiden Reaktionsbehältern durchgeführt werden oder durch Entnahme der polymerisierten Zusammensetzung aus dem ersten Reaktionsbehälter und Zugabe in den zweiten Reaktionsbehälter.

In der alternativen Ausführung des erfindungsgemäßen Verfahrens, bei der ein einziger Reaktionsbehälter verwendet wird, wird in einer noch vorteilhafteren Weise sowohl die Polymerisation mittels akustischer Kavitation gemäß Schritt c), als auch eine anschließende Aerosolbildung mittels akustischer Kavitation und/oder Kapillarwellen durchgeführt. Dieses Verfahren stellt beträchtliche Vorteile gegenüber dem Stand der Technik dar, da nun erfindungsgemäß sowohl die Polymerisation als auch die Aerosolbildung einer Zusammensetzung enthaltend Hydridosilane in-situ ermöglicht wird.

Die Polymerisationsgeschwindigkeit (Anstieg der molaren Masse (g/mol) pro Zeit) und Aerosolbildungsrate (Volumen der erzeugten Aerosole pro Zeit), die Polymerisationsausbeute (prozentualer Anteil der monomeren Hydridosilane, die zu höheren Hydridosilanen polymerisiert sind), und der Aerosolfluss in Richtung Substrat (Volumen der erzeugten Aerosole pro Zeit pro Fläche) können durch die Konzentration der zugegebenen Nanopartikel, die Restkonzentration der Edukte (monomeren Hydridosilane), den Betriebsmodus (d.h. kontinuierlich oder gepulst), die Amplitude und Frequenz der Ultraschallquelle/des Schallwandlers, die die akustische Kavitation und/oder Kapillarwellen erzeugt, als auch über Abkühleinrichtungen eingestellt werden.

Die Nanopartikel, die zugesetzt werden können, liegen in einem Größenbereich von < 100 nm, bevorzugt im Bereich < 50 nm. Die Nanopartikel können beispielsweise separat hergestellt und der Zusammensetzung zugegeben werden. Das erfindungsgemäße Verfahren ermöglicht eine in-situ Behandlung von Nanopartikeln, so dass deren Dispergierung, Deagglomerierung, Funktionalisierung und Einbettung in die erfindungsgemäße Vorrichtung, die gleichzeitig sowohl als Polymerisierungszelle als auch als Aerosolierungszelle eingesetzt werden kann, stattfinden kann. Dies hat den erheblichen Vorteil, dass z.B. instabile Nanopartikeldispersionen sukzessiv in-situ behandelt, in polymerisiertes/unpolymerisiertes Hydridosilan eingebettet, aerosoliert und auf ein Substrat aufgebracht werden können. Dabei kann sich das Substrat sowohl innerhalb als auch außerhalb der erfindungsgemäßen Vorrichtung befinden. Damit wird die Agglomeratbildung aus Nanopartikeln, welche ein materialtechnisch beträchtliches Problem darstellt, vermieden. Hierzu sind nach dem bisherigen Stand der Technik zwei getrennte Schritte erforderlich, welche mindestens zwei unterschiedliche Apparaturen (z.B. eine "Kugelmühle" und einen "Spincoater") benötigen. Durch die vorliegende Erfindung kann dies vorteilhaft in einem Schritt und in einer Vorrichtung durchgeführt werden. Beispielhaft aber nicht beschränkend können hier Nanopartikel aus der Gruppe CuO, Cu₂O, Cu₂S, CuS, Fe₂O₃, FeS, FeS₂, FeSi₂, SnS, ZrS genannt werden.

Substrate mit einer glatten oder strukturierten Oberfläche können eingesetzt werden. Geeignet sind beispielsweise Glas-, Quarz-, Metall- oder kristalline Siliziumsubstrate. Dabei darf das Substrat auch gekrümmt oder flexibel sein. Die Substrate können auch mit einer geeigneten Beschichtung vorliegen, wie z.B. mit ZnO beschichtetes Glas mit oder ohne Strukturierung.

Das Substrat kann mit den erzeugten Aerosolen enthaltend Hydridosilane, Nanopartikel und/oder in Hydridosilane eingebettete Nanopartikeln, beschichtet werden. Das Substrat kann bei Verwendung von reinen flüssigen Hydridosilanen, mit gasförmigen Silanen und/oder festen Hydridosilanen mit einer molaren Masse zwischen 32 g/mol und 1·10⁶ g/mol beschichtet werden und bei Verwendung einer Hydridosilanlösung kann das Substrat sowohl mit gasförmigen Silanen und/oder flüssigen Hydridosilanen und/oder festen Hydridosilanen als auch mit diesen gasförmigen Silanen und/oder flüssigen Hydridosilanen und/oder festen Hydridosilanen, die in einem Lösungsmittel verdünnt und in Form von Lösungsmittel-Hydridosilan-Aerosoltröpfchen vorliegen, beschichtet werden. Bei Verwendung einer Hydridosilanlösung wird beispielsweise eine 1-30 Gew.%ige Hydridosilanlösung eingesetzt (der Rest ist Lösungsmittel).

Durch Einstellung der Temperatur bzw. des Temperaturgradienten des Substrates, kann gezielt die Konzentration der Hydridosilane im noch zu konvertierenden und/oder zu trocknenden Flüssigkeitsfilm auf der Oberfläche des Substrates kontrolliert werden. Durch einen kontinuierlichen Aerosolzufluss auf das Substrat kann ein wachsender Siliziumfilm erzeugt werden, bei dem in vorteilhafter Weise die tieferen Siliziumschichten keinen direkten Kontakt zur Atmosphäre des Reaktionsraums haben, da sie durch die nachwachsenden äußeren Schichten vor einer möglichen Oxidation durch Restsauerstoff in der N₂-Atmosphäre zum Beispiel in einer Glovebox geschützt werden. In einer Glovebox liegt die Konzentration von H₂O und O₂ typischerweise bei < 1 ppm.

Die Temperatur, bei der die Konvertierung der Schicht aus höheren Hydridosilanen stattfindet, die Schichtwachstumsrate, sowie die Temperatur und Verdampfungsrate des Lösungsmittels, können durch das vorliegende Verfahren in vorteilhafter Weise präzise und gezielt eingestellt und kontrolliert werden. Dies hat erhebliche Vorteile bezüglich des Konvertierungsmechanismus der höheren Hydridosilane in einen festen, amorphen, dünnen Film. Da sowohl die Generationsrate und Zusammensetzung des Aerosols exakt eingestellt werden kann, als auch die Aerosolbildung sofort gestartet bzw. gestoppt, als auch präzise auf das Substrat gerichtet werden kann, weist das erfindungsgemäße Polymerisations- und Beschichtungsverfahren erhebliche Vorteile gegenüber dem Stand der Technik auf.

Sowohl Tröpfchen als auch volatile Hydridosilane können auf das Substrat abgeschieden werden. Niedere Hydridosilane wie z.B. Trisilan (Si₃H₈) sind leicht flüchtig und werden in der Gasphase auf das zu beschichtende Substrat aufgebracht. Lösliche und nicht zu schwere Hydridosilane (bis zu einer molaren Masse von ca. 1·10⁴ g/mol) werden als Aerosoltröpfchen oder -teilchen zum Substrat transportiert. Hydridosilane mit einer hohen molaren Masse (z.B. > 1·10⁴ g/mol), die weder im Lösungsmittel noch in anderen Silanen wie z.B. Cyclopentasilan löslich noch für die Beschichtung geeignet sind, werden im Reaktionsbehälter zurückgehalten. Letztere können im Reaktionsbehälter weiter beschallt werden, bis sie gegebenenfalls mittels Depolymerisation die geeignete molare Masse erreichen. Das erzeugte Aerosol hat einen typischen mittleren Tröpfchendurchmesser (MMD) zwischen 0,1 - 10 µm und wird mit einem Aerosolfluss zwischen 100 nl/min bis 100 ml/min zum Substrat geleitet. Der Aerosolfluss kann zusätzlich auch darüber eingestellt werden, indem ein Trägergas wie z.B. Ar oder N₂ benutzt wird, um die Aerosole schneller oder langsamer in Richtung Substrat zu transportieren.

Gemäß dem physikalischen Modell nach [5] ist die mittlere Tröpfchengröße des Aerosols, das mittels einer Ultraschallquelle/eines Schallwandlers generiert wird, proportional zu f-^{2/3} und zu S^{1/3} wobei *f* die Anregungsfrequenz und S die Oberflächenspannung der Lösung ist. So kann die Tröpfchengröße, in Abhängigkeit von der Frequenz der zu beaufschlagenden Ultraschallwellen, durch Auswahl des Lösungsmittels oder durch Anpassung der Oberflächenspannung der Lösung bestimmt bzw. eingestellt werden.

So kann für jede Zusammensetzung eine Kalibrationskurve erstellt werden, aus der hervorgeht, bei welcher Frequenz/Amplitude bzw. Beschallungsdauer, welche mittlere Teilchengröße des Aerosols und/oder welche aufgedampften Silanspezies und/oder höheren Hydridosilane entstehen bzw. welche Polymerisationsausbeute vorliegt.

Die Menge der Nanopartikel bzw. Hydridosilane, die auf das Substrat aufgebracht wird, kann abhängig von den gewünschten Prozessparametern, wie z.B. Nanopartikelbedeckung, Länge der Beschichtungsdauer bzw. Polymerisationsausbeute und/oder Endschichtdicke, beliebig eingestellt werden.

Durch empirische Voruntersuchungen kann eine Korrelation zwischen der Beschallungsdauer und der mittleren molaren Masse der sich im Aerosol befindenden Polymerisate mittels GPC (Gel-Permeations-Chromatographie) oder NMR (Nuclear Magnetic Resonance) bestimmt werden. So kann beispielsweise für jede eingesetzte Zusammensetzung bestimmt werden, welche Beschallungsdauer eingestellt werden muss, um Hydridosilane mit der gewünschten molaren Masse zu erzeugen.

Die Beschichtungsqualität, die morphologischen und elektronischen Eigenschaften und die elementare Zusammensetzung der Schichten können beispielsweise mittels Lichtmikroskopie, AFM (Rasterkraftmikroskopie), REM (Rasterelektronenmikroskopie), Profilometrie, Raman Spektroskopie, FT-IR (Fourier-Transform-Infrarotspektrometrie), PDS (Photothermal Deflection Spectroscopy), SIMS (Secondary Ion Mass Spectroscopy) oder Wasserstoff-Effusionsmessungen kontrolliert und charakterisiert werden und gleichzeitig zur Einstellung der Beschichtungsparameter verwendet werden.

Die Beschichtung kann in einem Depositionsschritt, exklusive Trocknung und Konvertierung durchgeführt werden. Die Beschichtung erfolgt so lange, bis die gewünschte Endschichtdicke erreicht ist. Eine mehrstufige Beschichtung ist ebenfalls möglich, um beispielsweise Schichten unterschiedlicher Zusammensetzung aufzubringen.

Die Molekulargröße der Hydridosilane, mit denen das Substrat beschichtet wird, kann durch Verwendung eines Molekularfilters, der beispielsweise an der Ausgangsöffnung des Reaktionsbehälters bzw. an der Aerosolierungzelle angeordnet ist, eingestellt werden. Dieser lässt nur Moleküle der gewünschten Größe passieren, die sich dann auf dem Substrat anlagern. Die Teilchengröße kann zusätzlich mittels eines Heizelements an der Öffnung des Reaktionsbehälters bzw. der Aerosolierungzelle eingestellt werden. Durch die Temperierung des Öffnungshalses oder mittels Durchfluss des Aerosols neben dem Heizelement selbst kann eine partielle Verdunstung des jeweils noch vorhandenen Lösungsmittels in den Aerosolteilchen erreicht werden, so dass die Teilchengröße des Aerosols und damit die Konzentration von Hydridosilanen bzw. Nanopartikeln, die auf das Substrat aufgebracht werden, reguliert werden kann. Die mittlere Größe der Aerosolteilchen ist u.a. von der Nanopartikel- und (monomeren und polymeren) Hydridosilan-Konzentration abhängig.

Die Aerosolteilchen/Aerosoltröpfchen können durch eine verschließbare Öffnung oder durch einen Verschluss im Reaktionsbehälter bzw. in der Aerosolierungzelle gerichtet zur Substratoberfläche geleitet werden. Das Substrat kann sich dabei auch in einem bewegten oder rotierten Zustand befinden. Der Aerosolstrahl kann beispielsweise auch über Düsen oder durch die nach dem Stand der Technik bekannte Tintenstrahltechnologie wie in [EP 1087428 A1] gezielt auf das Substrat gerichtet werden.

An Stelle der Umsetzung der Reaktionsprodukte aus Schritt c) in Aerosole und deren Verwendung zur Beschichtung der Substratoberfläche, kann die Beschichtung der Oberfläche des Substrats mit dem nach dem Stand der Technik bekannten Rotationsbeschichtungsverfahren und/oder Tauchbeschichtungsverfahren und/oder Rakelbeschichtungsverfahren und/oder Tintenstrahldruckverfahren durchgeführt werden. Hierzu können die Reaktionsprodukte gemäß Schritt c) beispielsweise direkt durch Rotationsbeschichtung oder durch ein anderes zuvor genanntes Verfahren auf die Oberfläche des Substrats aufgebracht werden.

Zur Herstellung einer dotierten Siliziumschicht können Dotierstoffe durch Einmischen in die Zusammensetzung gemäß Schritt b) oder nach der Polymerisation gemäß Schritt c) auf das Substrat aufgebracht werden.

Zur Verbesserung der Schichteigenschaften kann nach der Beschichtung der Substratoberfläche eine Konvertierung in einer Niederdruck- und/oder wasserstoffhaltiger Atmosphäre durchgeführt werden. Eine Nachbehandlung der Siliziumschicht in einer reduzierenden Wasserstoffatmosphäre ist vorteilhaft, um das Silizium zu hydrieren, d.h. das Silizium zu passivieren, in dem u.a. "dangling bonds" (= ungesättigte Siliziumbindungen) mit Wasserstoff abgesättigt werden. Eine Konvertierung in einer Wasserstoffatmosphäre ist möglicherweise auch vorteilhaft, da auf diese Weise der Wasserstoffkonzentrationsgradient inner- und außerhalb der siliziumhaltigen Schicht reduziert werden könnte. Dies kann die Regulierung des Wasserstoffgehalts der Schicht nach der Konvertierung ermöglichen bzw. die Defektdichte der Schicht erniedrigen.

In einer vorteilhaften Ausgestaltung des Verfahrens kann während der Polymerisation gemäß Schritt c) eine UV-Bestrahlung vorgenommen und/oder thermische Energie zugeführt werden, die unterstützend zu einer Beschleunigung der Polymerisationsreaktionen, d.h. einer schnelleren Umsetzung der Edukte in die Produkte führen.

Eine Vorrichtung, die zur Polymerisation einer Zusammensetzung enthaltend Hydridosilane und anschließender Verwendung der Polymerisate zur Herstellung von siliziumhaltigen Schichten geeignet ist, umfasst wenigstens einen Reaktionsbehälter beinhaltend eine Zusammensetzung enthaltend wenigstens ein Hydridosilan, das entweder in mindestens einem organischen und/oder anorganischen Lösungsmittel gelöst ist oder wenigstens ein Hydridosilan, das ohne Lösungsmittel bereits flüssig vorliegt, wobei die Hydridosilane wenigstens ein lineares und/oder verzweigtes Hydridosilan der allgemeinen Formel SiₙH₂ₙ+₂ mit n ≥ 3 und/oder ein zyklisches Hydridosilan der allgemeinen Formel SiₙH₂ₙ mit n ≥ 3 umfassen und/oder beinhaltend die zuvor genannte Hydridosilanlösung oder das reine flüssige Hydridosilan, denen wenigstens Mono- und/oder Disilan- und/oder ein Borhaltiger Dotierstoff und/oder Phosphorhaltiger Dotierstoff und/oder Edelgas aus der Gruppe Ar, He und/oder Nanopartikel und/oder ein Polymerisationsinitiator und/oder ein Katalysator und/oder oberflächenspannungsmodifizierende Mittel zugesetzt werden und eine Ultraschallquelle und/oder ein Schallwandler zur Erzeugung akustischer Kavitation, wobei der Reaktionsbehälter wenigstens eine verschließbare Öffnung aufweist und das zu beschichtende Substrat gegenüber der Öffnung angeordnet ist und das Substrat an der Fläche, die von der Beschichtungsfläche abgewandt ist, eine Heizquelle aufweist.

Die Ultraschallquelle und/oder der Schallwandler für die Erzeugung der akustischen Kavitation kann eine magnetostriktive oder piezoelektrische Ultraschallquelle und/oder ein flüssigkeitsbetriebener oder gasbetriebener Schallwandler sein. Beispielhaft können hier Sonotroden und/oder Piezokeramiken genannt werden. Diese Ultraschallquelle oder der Schallwandler kann sich entweder im Reaktionsbehälter oder im Intermedium befinden.

Die Ultraschallwellen können über das Intermedium an die Zusammensetzung weitergeleitet werden. In einer Ausführung der erfindungsgemäßen Vorrichtung werden die Ultraschallwellen vorzugsweise mittels einer Piezokeramik, auf einen Brennpunkt im Reaktionsbehälter fokussiert.

Bei Sonotroden liegt ein geeigneter Frequenzbereich beispielsweise bei 20 - 50 kHz. Bei Piezokeramiken liegt ein geeigneter Frequenzbereich beispielsweise bei 500 kHz - 10 MHz.

Der Reaktionsbehälter kann sich teilweise oder ganz in einem mit Kühlmittelein- und Auslass versehenen Kühlmittelbehälter befinden.

Der Behälter sollte wenigstens eine verschließbare Öffnung, insbesondere für den Aerosolauslass aufweisen. Eine kleine (ca. 10 mm²) Öffnung oder mehrere kleine Öffnungen (Gesamtfläche ca. 100 mm²) ermöglichen es, dass das im Reaktionsbehälter (in diesem Fall auch als Aerosolierungszelle bezeichnet) erzeugte Aerosol in einen gerichteten Aerosolstrahl umgewandelt werden kann. Mit einem Molekularfilter ist es möglich, die molare Masse der ausgedampften Spezies bzw. der in den Aerosolteilchen suspendierten Spezies bzw. der sich in Lösung befindenden Hydridosilane zu regulieren. Die mittlere Teilchengröße des Aerosols ist von der monomeren und polymeren Hydridosilan- und Nanopartikel-Konzentration in der jeweiligen Lösung abhängig. Wird innerhalb der Vorrichtung sowohl das Verfahren zur Polymerisation als auch die Aerosolbildung durchgeführt, kann es vorteilhaft sein, im ersten Schritt zur Polymerisation der Zusammensetzung die Öffnungen des Behälters zunächst zu schließen und nach Erreichen der gewünschten mittleren molaren Masse der Polymerisate und in dem zweiten Verfahrensschritt der Aerosolbildung aus den Reaktionsprodukten der Zusammensetzung, die Öffnungen für die Beschichtung der Substratoberfläche mit den Aerosolen wieder zu öffnen.

In einer vorteilhaften Ausführung für den Fall der Verwendung einer Zusammensetzung enthaltend Hydridosilane und/oder Nanopartikel gelöst in einem Lösungsmittel, kann der Öffnungshals des Reaktionsbehälters bzw. der Aerosolierungszelle mit einem Heizelement, z.B. einer Heizwendel, und einer Stromquelle versehen werden. Durch die Temperierung des Öffnungshalses oder mittels Durchfluss des Aerosols neben dem Heizelement selbst kann eine partielle Verdunstung des jeweils noch vorhandenen Lösungsmittels in den Aerosolteilchen erreicht werden, so dass die Tröpfchengröße des Aerosols und damit die Konzentration von Hydridosilanen bzw. Nanopartikeln, die auf das Substrat aufgebracht werden, reguliert werden kann.

Der Reaktionsbehälter kann neben der verschließbaren Öffnung wenigstens ein weiteres Zu-/Ableitungsrohr, insbesondere ein zweites Zu-/Ableitungsrohr aufweisen. Mit diesen zusätzlichen Zu-/Ableitungsrohren kann beispielsweise ein gasförmiges Silan, ein Dotierstoff (fest, flüssig oder gasförmig) oder ein Edelgas dem Reaktionsbehälter zugesetzt werden. Für diese Anwendung sollte das Zu-/Ableitungsrohr bevorzugt so angebracht sein, dass die Eingangsöffnung des Rohrs in der Höhe angebracht ist, in der sich auch die Zusammensetzung befindet, damit das jeweilige Additiv direkt in die Zusammensetzung eingeleitet werden kann.

Die zusätzlichen Zu/-Ableitungsrohre können vorteilhaft dazu genutzt werden, die Zusammensetzung in bzw. aus dem Reaktionsbehälter zu befördern bzw. die Zusammensetzung zwischen diesen oder zu anderen Apparaturen und Vorrichtungen, z.B. GPC-Gerät, Molekularfilter, oder auch zu einer Aerosolierungszelle, zu transferieren.

In einer weiteren vorteilhaften Ausführung kann die Vorrichtung dadurch gekennzeichnet sein, dass sie neben einem ersten Reaktionsbehälter, enthaltend eine Zusammensetzung enthaltend wenigstens ein Hydridosilan, das entweder in mindestens einem organischen und/oder anorganischen Lösungsmittel gelöst ist oder wenigstens ein Hydridosilan, das ohne Lösungsmittel bereits flüssig vorliegt, wobei die Hydridosilane wenigstens ein lineares und/oder verzweigtes Hydridosilan der allgemeinen Formel SiₙH₂ₙ+₂ mit n ≥ 3 und/oder ein zyklisches Hydridosilan der allgemeinen Formel SiₙH₂ₙ mit n ≥ 3 umfassen oder eine der zuvor genannten Zusammensetzungen, der Mono- und/oder Disilan- und/oder ein Borhaltiger Dotierstoff und/oder ein Phosphorhaltiger Dotierstoff und/oder Edelgas aus der Gruppe Ar, He und/oder Nanopartikel und/oder ein Polymerisationsinitiator und/oder ein Katalysator und/oder oberflächenspannungsmodifizierende Mittel zugesetzt werden und der eine Ultraschallquelle oder einen Schallwandler zur Erzeugung akustischer Kavitation aufweist, einen zweiten Reaktionsbehälter aufweist, der eine Ultraschallquelle oder Schallwandler zur Erzeugung akustischer Kavitation und/oder Kapillarwellen aufweist, sowie wenigstens eine Öffnung aufweist und bei dem das zu beschichtende Substrat gegenüber der Öffnung angeordnet ist und das Substrat an der Fläche, die von der Beschichtungsfläche abgewandt ist, eine Heizquelle aufweist, wobei der zweite Reaktionsbehälter entweder wenigstens eine weitere Öffnung zum Zuführen und Abführen von Flüssigkeiten aufweist und/oder über wenigstens eine Leitung mit dem ersten Reaktionsbehälter verbunden ist.

Der erste Reaktionsbehälter kann als Ultraschallquelle zur Erzeugung der akustischen Kavitation eine Sonotrode aufweisen und der zweite Reaktionsbehälter (= Aerosolierungszelle) kann als Ultraschallquelle zur Erzeugung der akustischen Kavitation und/oder Kapillarwellen eine Piezokeramik aufweisen.

### Spezieller Beschreibungsteil

Nachfolgend wird der Gegenstand der Erfindung anhand von Ausführungsbeispielen und Figuren näher erläutert, ohne dass der Gegenstand der Erfindung dadurch beschränkt wird.

### Ausführungsbeispiele

### Beispiel 1 - Polymerisation einer Zusammensetzung mittels Piezokeramik

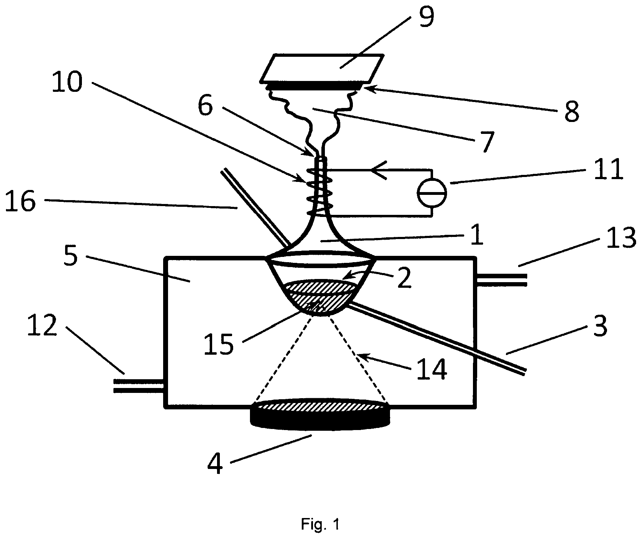

Eine Zusammensetzung mit einem Volumen von 1 ml enthaltend 7,7 Gew.% Cyclopentasilan in Cyclooctan wurde in den Reaktionsbehälter (1) gegeben und bei einer Prozesstemperatur von ca. 60°C für ca. 220 Minuten mit einer Ultraschallfrequenz von ungefähr 2 Megahertz (MHz) beschallt und mittels akustischer Kavitation zur Polymerisation gebracht, bis eine leichte Trübung der Lösung zu erkennen war. Dazu wurde eine Piezokeramik und die Vorrichtung gemäß Figur 1 eingesetzt. Für die Polymerisation wurde die Öffnung (6) der Vorrichtung verschlossen. Die mittlere molare Masse Mw der erfindungsgemäß hergestellten Polymerisate, ermittelt über Gel-Permeations-Chromatographie (GPC), betrug beispielsweise 1416 g/mol.

### Beispiel 2 - Polymerisation einer Zusammensetzung mittels Sonotrode

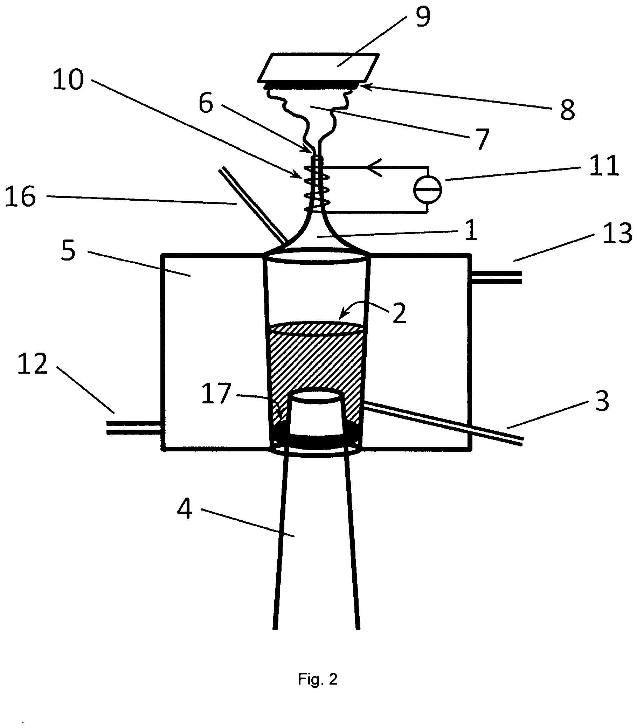

Eine Zusammensetzung mit einem Volumen von 0,8 ml enthaltend 5,6 Gew.% Cyclopentasilan in Cyclooctan wurde in den Reaktionsbehälter (1) gegeben und bei einer Prozesstemperatur von unter 65°C für ca. 50 Minuten mit einer Ultraschallfrequenz von ungefähr 25 Kilohertz (kHz) beschallt und mittels akustischer Kavitation zur Polymerisation gebracht, bis eine leichte Trübung zu erkennen war. Dazu wurde eine Sonotrode und die Vorrichtung gemäß Figur 2 eingesetzt. Für die Polymerisation wurde die Öffnung (6) der Vorrichtung verschlossen. Die mittlere molare Masse Mw der erfindungsgemäß hergestellten Polymerisate, ermittelt über Gel-Permeations-Chromatographie (GPC), betrug 1430 g/mol.

### Beispiel 3 - Beschichtung eines Substrats mit Polymerisaten mittels Rotationsbeschichtung

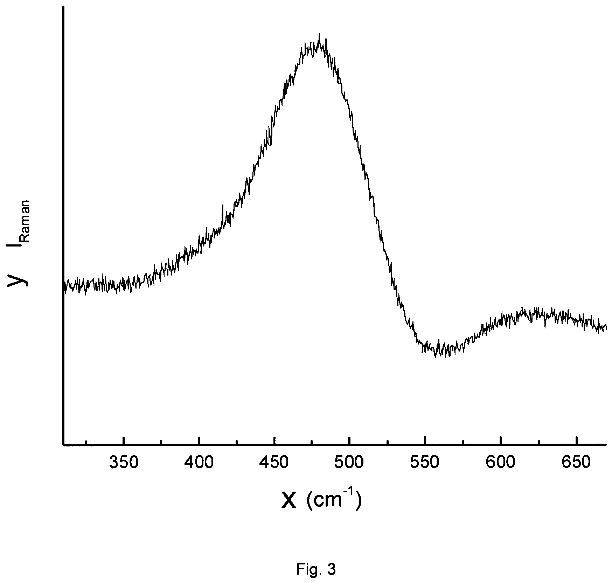

Die Reaktionsprodukte aus Beispiel 1, enthaltend höhere Hydridosilane, wurden anschließend über das Zu-/Ableitungsrohr (3) aus der Vorrichtung entnommen und mittels der nach dem Stand der Technik bekannten Rotationsbeschichtung mit einer Rotationsgeschwindigkeit von 2000 Umdrehungen pro Minute (rpm) für 45 Sekunden auf ein Glassubstrat aufgebracht. Nach einer Konvertierung auf einer Heizplatte bei ca. 350°C wies die Schicht eine Dicke von 25 nm auf. In Figur 3 ist ein Ramanspektrum dieser Siliziumschicht gezeigt, in dem zu sehen ist, dass die Schicht aufgrund des transversal-optischen (TO) Raman-Streuungspeaks bei ca. Wellenzahl 480 cm⁻¹ einen vollkommen amorphen Charakter aufweist.

Die Reaktionsprodukte aus Beispiel 2 wurden ebenfalls mittels Rotationsbeschichtung bei 2000 rpm für 50 Sekunden auf ein Glassubstrat aufgebracht und anschließend bei ca. 350°C konvertiert. Die Dicke der resultierenden amorphen Schicht betrug 38 nm.

### Beispiel 4 - Beschichtung eines Substrats mit Nanopartikeln mit Hilfe von Nanopartikel-Aerosoltröpfchen

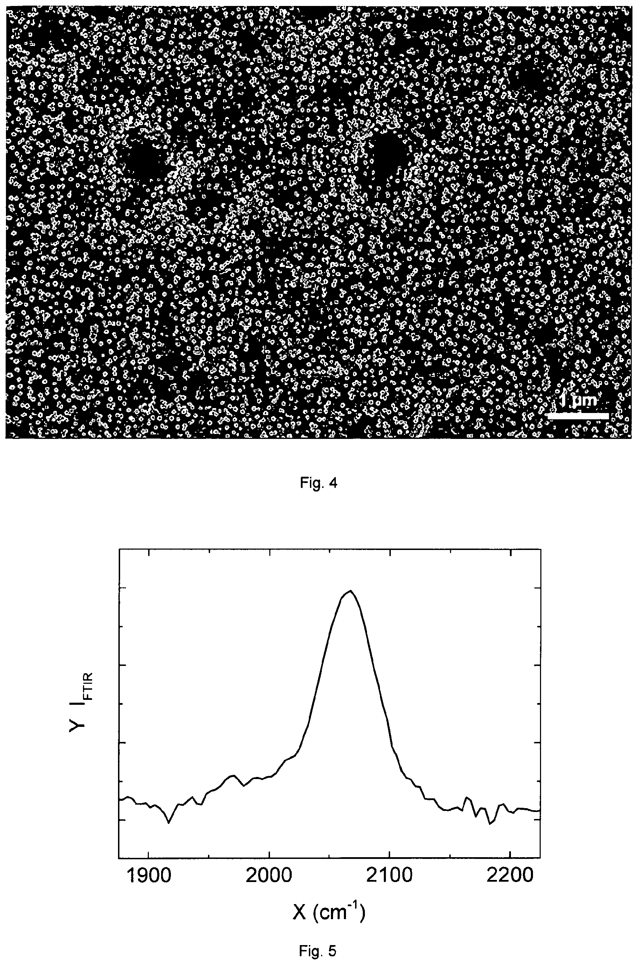

Eine Zusammensetzung enthaltend Fe₂O₃ Nanopartikel mit ca. 40 nm Durchmesser wurde in einem organischen/anorganischen Lösungsmittelgemisch dispergiert, in den Reaktionsbehälter (1) gegeben und anschließend mittels akustischer Kavitation und/oder Kapillarwellen in Nanopartikel-Aerosoltröpfchen umgesetzt und auf eine strukturierte Substratoberfläche aufgebracht. Dazu wurde eine Piezokeramik und die Vorrichtung gemäß Figur 1 eingesetzt. Die Beschichtung der Substratoberfläche mit den Nanopartikel-Aerosoltröpfchen erfolgte bei Raumtemperatur (ca. 23°C) und innerhalb einer Beschichtungsdauer von ca. 3 Sekunden. Die durch die Piezokeramik ausgelöste akustische Kavitation und Kapillarwellenbildung führte zur Bildung von Nanopartikel-Aerosoltröpfchen, die durch die Öffnung (6) des Reaktionsbehälters (1) wanderten und sich auf dem Substrat (8) anlagerten, welches gegenüber der Öffnung (6) angeordnet ist. Wie aus der Figur 4 zu erkennen ist, verteilen sich die in den Aerosoltröpfchen enthaltenen Nanopartikel gleichmäßig/homogen über die gesamte, mit Ätzkratern strukturierte Substratoberfläche.

Mit den folgenden Ausführungsbeispielen kann das erfindungsgemäße Polymerisationsverfahren eines Hydridolsilans, insbesondere eines niederen Silans, mittels akustischer Kavitation demonstriert werden:

### Beispiel 5 - Beschichtung eines Substrats mit einer Zusammensetzung enthaltend Trisilan ohne erfindungsgemäßes Polymerisationsverfahren

Einer Zusammensetzung mit einem Volumen von 0,6 ml enthaltend 11 Gew.% Trisilan in Cyclooctan werden ca. 20µl entzogen und mittels der nach dem Stand der Technik bekannten Rotationsbeschichtung mit einer Rotationsgeschwindigkeit von 2000 Umdrehungen pro Minute (rpm) für 20 Sekunden auf ein Glassubstrat aufgebracht. Nach Aufheizen dieses Glassubstrats auf einer Heizplatte bei 450°C für 5 Minuten wurde keinerlei Schichtbildung beobachtet.

### Beispiel 6 - Beschichtung eines Substrats mit einer thermisch behandelten Zusammensetzung enthaltend Trisilan ohne erfindungsgemäßes Polymerisationsverfahren

Eine Zusammensetzung mit einem Volumen von 0,6 ml enthaltend 11 Gew.% Trisilan in Cyclooctan wird auf einer Heizplatte in einem offenen Glasgefäß für 625 Minuten aufgeheizt, so dass die Zusammensetzung eine Temperatur zwischen 70 bis 75°C erreicht. Dabei wird regelmäßig frisches Trisilan zugegeben, um Verdunstungsverluste zu kompensieren. Die Zusammensetzung bleibt nach dieser Behandlung transparent. Dieser Zusammensetzung werden ca. 20 µl entzogen und mittels der nach dem Stand der Technik bekannten Rotationsbeschichtung mit einer Rotationsgeschwindigkeit von 2000 Umdrehungen pro Minute (rpm) für 20 Sekunden auf ein Glassubstrat aufgebracht. Nach Aufheizen dieses so behandelten Glassubstrats auf einer Heizplatte bei 450°C für 5 Minuten wurde keinerlei Schichtbildung beobachtet.

### Beispiel 7 - Beschichtung eines Substrats mit einer mittels akustischer Kavitation behandelten Zusammensetzung enthaltend Trisilan

Eine Zusammensetzung mit einem Volumen von 1 ml enthaltend 18 Gew.% Trisilan in Cyclooctan wird für 145 Minuten in einem offenen Glasgefäß mit einer Sonotrode behandelt. Die Temperatur der Zusammensetzung bleibt dabei stabil bei ca. 70°C. Dabei zeigt die Zusammensetzung nach 70 Minuten Beschallung mit der Sonotrode eine hellbraune Färbung und nach ca. 130 Minuten eine dunkelgraue Färbung. Der Zusammensetzung werden ca. 20µl entzogen und mittels der nach dem Stand der Technik bekannten Rotationsbeschichtung mit einer Rotationsgeschwindigkeit von 2000 Umdrehungen pro Minute (rpm) für 20 Sekunden auf ein Glassubstrat aufgebracht. Nach Aufheizen dieses so behandelten Glassubstrats auf einer Heizplatte bei 450°C für 5 Minuten ist auf der Oberfläche die Ausbildung von hellbraunen, festen Siliziumrückständen zu beobachten.

### Beispiel 8 - Beschichtung eines Substrats mit einer mittels UV-Bestrahlung behandelten Zusammensetzung enthaltend Trisilan

Eine Zusammensetzung mit einem Volumen von 0,6 ml enthaltend 11 Gew.% Trisilan in Cyclooctan wird für 700 Minuten mit UV-Licht einer Wellenlänge von 365 nm bestrahlt. Die Zusammensetzung bleibt nach dieser Bestrahlung transparent. Dieser so behandelten Zusammensetzung werden 20 µl entzogen und mittels der nach dem Stand der Technik bekannten Rotationsbeschichtung mit einer Rotationsgeschwindigkeit von 2000 Umdrehungen pro Minute (rpm) für 20 Sekunden auf ein Glassubstrat aufgebracht. Nach Aufheizen dieses Glassubstrats auf einer Heizplatte bei 450°C für 5 Minuten wurde keinerlei Schichtbildung festgestellt.

### Beispiel 9 - Beschichtung eines Substrats mit einer mittels akustischer Kavitation und UV-Bestrahlung behandelten Zusammensetzung enthaltend Trisilan

Der Zusammensetzung aus Beispiel 7, die, wie in Beispiel 7 beschrieben, mittels akustischer Kavitation behandelt wurde, werden 0,2 ml entzogen und mit 50 µl frischem Trisilan gemischt. Diese Zusammensetzung wird nun für 300 Minuten mit UV-Licht einer Wellenlänge von 365 nm bestrahlt. Es wird eine zitronengelbe Färbung der Zusammensetzung beobachtet. Dieser so behandelten Zusammensetzung werden 20 µl entzogen und mittels der nach dem Stand der Technik bekannten Rotationsbeschichtung mit einer Rotationsgeschwindigkeit von 2000 Umdrehungen pro Minute (rpm) für 20 Sekunden auf ein Glassubstrat aufgebracht. Nach Aufheizen dieses Glassubstrats auf einer Heizplatte bei 450°C für 5 Minuten wurde die Bildung einer ca. 20 nm dicken, hellorangen Siliziumschicht festgestellt.

Es ist gezeigt:
Figur 1 zeigt eine Vorrichtung, die zur Ausführung des erfindungsgemäßen Verfahrens, insbesondere sowohl zur Polymerisation als auch zur Aerosolbildung, geeignet sein kann.
Figur 2 zeigt eine alternative Vorrichtung, die ebenfalls zur Ausführung des erfindungsgemäßen Verfahrens, insbesondere sowohl zur Polymerisation als auch zur Aerosolbildung, geeignet sein kann.

Eine geeignete Vorrichtung zur Ausführung des erfindungsgemäßen Verfahrens gemäß Figur 1 umfasst einen Reaktionsbehälter (1) mit einer Zusammensetzung (2), enthaltend wenigstens ein Hydridosilan, das entweder in mindestens einem organischen und/oder anorganischen Lösungsmittel gelöst ist oder wenigstens ein Hydridosilan, das ohne Lösungsmittel bereits flüssig vorliegt, wobei die Hydridosilane wenigstens ein lineares und/oder verzweigtes Hydridosilan der allgemeinen Formel SiₙH₂ₙ+₂ mit n ≥ 3 und/oder ein zyklisches Hydridosilan der allgemeinen Formel SiₙH₂ₙ mit n ≥ 3 umfassen und/oder beinhaltend die zuvor genannte Hydridosilanlösung oder das reine bereits flüssige Hydridosilan, denen wenigstens Mono- und/oder Disilan- und/oder ein Borhaltiger Dotierstoff und/oder Phosphorhaltiger Dotierstoff und/oder Edelgas aus der Gruppe Ar, He und/oder Nanopartikel und/oder ein Polymerisationsinitiator und/oder ein Katalysator und/oder oberflächenspannungsmodifizierende Mittel zugesetzt werden. Die Vorrichtung umfasst weiterhin eine Ultraschallquelle oder einen Schallwandler (4) zur Erzeugung akustischer Kavitation und/oder Kapillarwellen. Der Reaktionsbehälter (1) befindet sich (teilweise oder ganz) in einem mit Kühlmittelein- (12) und Auslass (13) versehenen Kühlmittelbehälter (5). In der vorliegenden Ausgestaltung der Vorrichtung wird als Ultraschallquelle (4) eine Piezokeramik eingesetzt, die nicht in direktem Kontakt mit der Zusammensetzung steht, sondern über ein Intermedium, in diesem Fall beispielsweise ein Kühlmedium in einem Kühlmittelbehälter (5), die Ultraschallwellen (14) auf den Reaktionsbehälter (1), der von dem Kühlmittel umgeben ist, überträgt. Der Reaktionsbehälter (1) weist eine verschließbare Öffnung (6), insbesondere für das Aerosol (7) auf. Zur Beschichtung der Substratoberfläche kann die in einem ersten Verfahrensschritt erfindungsgemäß polymerisierte Zusammensetzung entweder aus dem Reaktionsbehälter (1) über eine der Öffnungen (3, 6, 16) entnommen werden und beispielsweise für eine anschließende Rotationsbeschichtung verwendet werden oder sie verbleibt in dem Reaktionsbehälter (1) und wird in einem anschließenden Verfahrensschritt erfindungsgemäß in Aerosoltröpfchen/Aerosole umgesetzt. Das zu beschichtende Substrat (8) kann gegenüber der Öffnung (6) angeordnet sein. Das Substrat (8) weist an der Fläche, die von der Beschichtungsfläche abgewandt ist, eine Heizquelle (9) auf. Für den Fall der Verwendung von Hydridosilanen, die in mindestens einem Lösungsmittel gelöst sind, kann der Öffnungshals des Reaktionsbehälters (1) in einer vorteilhaften Ausführung der Vorrichtung mit einer Heizwendel (10) und Stromquelle (11) versehen sein, um die Teilchengröße des Aerosols (7) zu regulieren, in dem durch die Wärmezufuhr das Lösungsmittel verdunsten kann. Die Ultraschallwellen (14) können auf einen Brennpunkt (15) im Reaktionsbehälter (1) fokussiert werden. Die Edukte und Produkte der Zusammensetzung (2) können mittels eines Zu/-Ableitungsrohrs (16) in den Reaktionsbehälter (1) hinein bzw. aus diesem heraus befördert werden. Weiterhin können durch das Zu-/Ableitungsrohr (16) beispielsweise auch gasförmige Silane, Dotierstoffe oder auch andere Gase zugegeben werden. Der Reaktionsbehälter (1) kann neben dem ersten Zu-/Ableitungsrohr (16), auch ein zweites Zu-/Ableitungsrohr (3), aufweisen.

In einer alternativen Ausführung der Vorrichtung, bei der die Ultraschallquelle ebenfalls über ein Intermedium auf die Zusammensetzung (2) einwirkt, kann auch eine Sonotrode eingesetzt werden. Dabei kann sich der Reaktionsbehälter (1) innerhalb eines mit Kühlmittel versehenen Kühlmittelbehälters (5), der sowohl Kühlmitteleinlass (12) als auch Kühlmittelauslass (13) aufweisen kann, befinden. Der Reaktionsbehälter (1) kann dazu schlauchartig, mit einer Aufweitung zur Aufnahme eines größeren Zusammensetzungsvolumens, ausgeführt sein und zwei, optional verschließbare, Öffnungen aufweisen. Diese Öffnungen ragen aus dem Kühlmittelbehälter (5) heraus, so dass von der Außenseite des Kühlmittelbehälters (5) Edukte und Produkte des erfindungsgemäßen Verfahrens durch diese Öffnungen zu- bzw. abgeführt werden können. Die Sonotrode ist so angeordnet, dass sie in das Kühlmittel hineinragt und damit nur mit diesem Kühlmittel/Intermedium in direktem Kontakt steht. Die Übertragung der Ultraschallwellen (14) auf die Zusammensetzung (2) in dem Reaktionsbehälter (1) zur Polymerisation der Zusammensetzung erfolgt daher auch hier indirekt über das Kühlmedium, welches damit auch die Funktion eines Intermediums erfüllt. Die Sonotrode (4) kann, abgedichtet z.B. über einen O-Ring, im Kühlmittelbehälter (5) verbleiben. Zur Beschichtung der Substratoberfläche kann die erfindungsgemäß polymerisierte Zusammensetzung entweder aus dem Reaktionsbehälter (1) über eine der Öffnungen entnommen werden und beispielsweise für eine anschließende Rotationsbeschichtung verwendet werden oder sie verbleibt in dem Reaktionsbehälter (1) und wird in einem anschließenden Verfahrensschritt erfindungsgemäß in Aerosolteilchen umgesetzt. Das zu beschichtende Substrat kann dazu wahlweise vor einer oder auch beiden Öffnungen angeordnet werden, so dass sich die gebildeten Aerosolteilchen auf diese Oberfläche anlagern können. Das Substrat (8) kann hier wie schon zuvor beschrieben an der Fläche, die von der Beschichtungsfläche abgewandt ist, eine Heizquelle (9) aufweisen. Für den Fall der Verwendung von Hydridosilanen, die in mindestens einem Lösungsmittel gelöst sind, kann eine oder beide der Öffnungen des Reaktionsbehälters (1) in einer vorteilhaften Ausführung der Vorrichtung mit einer Heizwendel (10) und Stromquelle (11) versehen sein, um die Teilchengröße des Aerosols (7) zu regulieren, in dem durch die Wärmezufuhr das Lösungsmittel verdunsten kann.

Figur 2 zeigt eine weitere Vorrichtung, die ebenfalls zur Ausführung des erfindungsgemäßen Verfahrens geeignet ist. Diese Vorrichtung gemäß Figur 2 umfasst ebenfalls einen Reaktionsbehälter (1) mit einer Zusammensetzung (2), enthaltend wenigstens eine Hydridosilanlösung, umfassend mindestens ein lineares oder verzweigtes Hydridosilan der allgemeinen Formel SiₙH₂ₙ+₂ mit n ≥ 3 und/oder ein zyklisches Hydridosilan der allgemeinen Formel SiₙH₂ₙ mit n ≥ 3, die in mindestens einem Lösungsmittel gelöst sind, oder eine reine Flüssigsilanlösung, umfassend ein oder mehrere flüssige Hydridosilane, die ohne Lösungsmittel bereits flüssig vorliegen oder eine Lösung, der optional wenigstens Mono- und/oder Disilan- und/oder Borhaltiger Dotierstoff und/oder ein Phosphorhaltiger Dotierstoff und/oder Edelgas aus der Gruppe He, Ar und/oder Nanopartikel und/oder ein Polymerisationsinitiator und/oder ein Katalysator und/oder oberflächenspannungsmodifizierende Mittel zugesetzt wird/werden. Die Vorrichtung weist eine Ultraschallquelle (4) zur Erzeugung akustischer Kavitation und/oder Kapillarwellen auf. Im hier dargestellten Beispiel wurde eine Sonotrode eingesetzt. Der Reaktionsbehälter (1) befindet sich (teilweise oder ganz) in einem mit Kühlmittelein- (12) und Auslass (13) versehenen Kühlmittelbehälter (5). Der Reaktionsbehälter (1) weist eine Öffnung (6) insbesondere für das Aerosol (7) auf. Das zu beschichtende Substrat (8) ist gegenüber der Öffnung (6) angeordnet. Das Substrat (8) weist an der Fläche, die der Beschichtungsfläche abgewandt ist, eine Heizquelle (9) auf. Für den Fall der Verwendung von Hydridosilanen, die in mindestens einem Lösungsmittel gelöst sind, ist der Öffnungshals des Reaktionsbehälters (1) mit einer Heizwendel (10) und Stromquelle (11) versehen, um die Teilchengröße des Aerosols (7) zu regulieren. Die Zusammensetzung (2) kann mittels eines Zu-/Ableitungsrohrs (16) in den Reaktionsbehälter (1) hinein bzw. aus diesem heraus befördert werden. Der Reaktionsbehälter (1) kann neben dem ersten (16) Zu-/Ableitungsrohr auch ein zweites Zu-/Ableitungsrohr (3), aufweisen. In Figur 2 ist die Ultraschallquelle (4) zur Erzeugung akustischer Kavitation und/oder Kapillarwellen eine Sonotrode, die so angeordnet, dass sie in den Reaktionsbehälter (1) mit der Zusammensetzung (2) hineinragt und dadurch in direktem Kontakt mit der Zusammensetzung (2) steht. Die Ultraschallquelle (4) kann, abgedichtet z.B. über einen O-Ring (17), im Reaktionsbehälter (1) verbleiben.

Figur 3 zeigt ein Ramanspektrum einer siliziumhaltigen Schicht nach der Konvertierung gemäß Ausführungsbeispiel 2. Die Abszisse X gibt die Wellenzahl in [cm⁻¹] an und die Ordinate Y gibt die Raman-Intensität I_{Raman} in dimensionsloser Einheit an. Der TO-Raman-Streuungspeak bei ca. 480 cm⁻¹ weist auf amorphes Silicium hin.

Figur 4 zeigt eine REM (Rasterelektronenmikroskopische)-Aufnahme einer in der Aerosolierungszelle mittels Aerosolbeschichtung mit Fe₂O₃ Nanopartikeln (weiße kreisförmige Punkte) bedeckten strukturierte p-Typ CVD-Siliziumschicht. Die dunkleren, kreisförmigen Bereiche entsprechen den Vertiefungen der Atzkrater.

Figur 5 zeigt ein Fourier-Transform-Infrarot-Spektroskopie (FTIR) Spektrum einer auf Silizium-Wafer aufgebrachten Trisilanprecursor basierten Schicht gemäß Beispiel 9. Die Abszisse X gibt die Wellenzahl in cm⁻¹ an. Die Ordinate Y gibt die FTIR Signalintensität I_{FTIR} in relativen Einheiten an. Die Moden zwischen den Wellenzahlen 2000-2080 cm⁻¹ sind charakteristisch für Si-H bzw. Si-H₂ Streckschwingungen in a-Si:H.

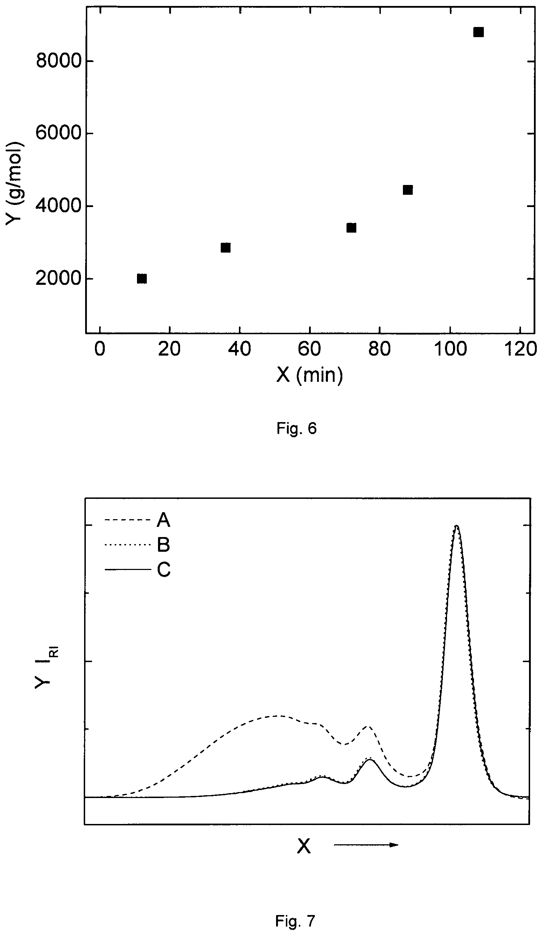

Figur 6 zeigt das Wachstum der Molekularmasse (Mw) einer mittels Ultraschallbehandlung polymerisierten Zusammensetzung enthaltend 10 Gew.% Cyclopentasilan (CPS) in Cyclooctan. Die Abszisse X gibt die Beschallungszeit in Minuten (min) an. Die Ordinate Y gibt die Molekularmasse Mw in Gramm pro Mol (g/mol) an. Die M_{W} wurde mittels Gel-Permeations-Chromatographie (GPC) mit Hilfe PS-Standards ermittelt.

Figur 7 zeigt GPC-Chromatogramme von (A) = einer für 188 Minuten beschallten CPS-Lösung, (B) = einer für 625 Minuten thermisch bei ca. 70°C behandelten CPS-Lösung, und (C) = einer unbehandelten CPS-Lösung. Die Abszisse X gibt die Elutionszeit an. Die Ordinate Y gibt die normierte Intensität des Brechungsindexdetektors I_{RI} an. Der scharfe Peak rechts im Chromatogramm wird durch nicht-umgesetztes CPS erzeugt. In Kurve (A), also der erfindungsgemäß behandelten CPS- Lösung, kann links vom CPS-Peak, im Gegensatz zu den Kurven (B) und (C), eine erhöhte Konzentration von Hydridosilanen ermittelt werden. Diese Beobachtung weist auf den erfindungsgemäßen nicht-photolytisch, nicht-thermisch basierten Effekt der Mw Zunahme bzw. Polymerisation eines Hydridosilans mittels Beschallung hin.

### In der Anmeldung zitierte Literatur:

[1] lyer, G., et al., Solution-Based Synthesis of Crystalline Silicon from Liquid Silane through Laser and Chemical Annealing, ACS Appl. Mater. Interfaces 4, 2680-2685 (2012)
[2] Shimoda, T., et al., Solution-Processed silicon films and transistors, Nature 440, 783-786 (2006)
[3] Masuda, T., et al., Fabrication of solution-processed hydrogenated amorphous silicon single-junction solar cells, Appl. Phys. Lett. 100, 253908 (2012)
[4] Suslick, K.S., Price, G.J., Applications of Ultrasound to Material Chemistry, Annu. Rev. Mater. Sci. 29, 295-326 (1999)
[5] Lang, R.J., Ultrasonic Atomization of Liquids, J. Acous. Soc. Am. 34, 1 (1962)
   [WO 2011/061106 A2]
   [DE 10 2010 041 842 A1]
   [WO 2012/084261 A1]
   [WO 2011/104147 A1]
   [EP 1087428 A1]

## Patentansprüche

1. Verfahren zur Polymerisation einer Zusammensetzung enthaltend Hydridosilane und anschließenden Verwendung der Polymerisate zur Herstellung von siliziumhaltigen Schichten umfassend folgende Schritte:
a) Bereitstellung eines Substrats.
b) Bereitstellung einer Zusammensetzung enthaltend wenigstens ein Hydridosilan, das entweder in mindestens einem organischen und/oder anorganischen Lösungsmittel gelöst ist oder enthaltend wenigstens ein Hydridosilan, das ohne Lösungsmittel bereits flüssig vorliegt, wobei die Hydridosilane wenigstens ein lineares und/oder ein verzweigtes Hydridosilan der allgemeinen Formel SiₙH₂ₙ+₂ mit n ≥ 3 und/oder ein zyklisches Hydridosilan der allgemeinen Formel SiₙH₂ₙ mit n ≥ 3 umfassen.
c) Polymerisation der Zusammensetzung aus Schritt b) mittels akustischer Kavitation.
d) Beschichtung der Oberfläche des Substrats mit Reaktionsprodukten aus Schritt c).

2. Verfahren nach Anspruch 1,
**dadurch gekennzeichnet,**
**dass** die Zusammensetzung aus Schritt b) wenigstens ein niederes Hydridosilan mit einer molaren Masse zwischen 90 und 305 g/mol, insbesondere aus der Gruppe Trisilan, Tetrasilan, Pentasilan, Hexasilan, Heptasilan, Cyclopentasilan, Cyclohexasilan oder Neopentasilan, umfasst.

3. Verfahren nach einem der Ansprüche 1 bis 2,
**dadurch gekennzeichnet,**
**dass** der Hydridosilanlösung oder dem reinen flüssigen Hydridosilan wenigstens Mono- und/oder Disilan- und/oder ein Borhaltiger Dotierstoff und/oder ein Phosphorhaltiger Dotierstoff und/oder Edelgas aus der Gruppe Ar, He und/oder Nanopartikel und/oder ein Polymerisationsinitiator und/oder ein Katalysator und/oder oberflächenspannungsmodifizierende Mittel zugesetzt wird/werden.

4. Verfahren nach einem der Ansprüche 1 bis 3,
**dadurch gekennzeichnet,**
**dass** die Reaktionsprodukte aus Schritt c) mittels akustischer Kavitation und/oder Kapillarwellen in Aerosole umgesetzt werden und diese zur Beschichtung gemäß Schritt d) mit der Oberfläche des Substrats in Kontakt gebracht werden.

5. Verfahren nach einem der Ansprüche 1 bis 4,
**dadurch gekennzeichnet,**
**dass** die akustische Kavitation mit Hilfe einer magnetostriktiven oder piezoelektrischen Ultraschallquelle und/oder eines flüssigkeitsbetriebenen oder gasbetriebenen Schallwandlers generiert wird.

6. Verfahren nach einem der Ansprüche 1 bis 5,
**dadurch gekennzeichnet,**
**dass** die Ultraschallquelle und/oder der Schallwandler zur Polymerisation gemäß Schritt c) und/oder zur Umsetzung der Reaktionsprodukte aus Schritt c) in Aerosole, in direkten Kontakt mit der Zusammensetzung aus Schritt b) bzw. c) gebracht wird oder über ein Intermedium mit der Zusammensetzung aus Schritt b) bzw. c) in Kontakt gebracht wird.

7. Verfahren nach einem der Ansprüche 1 bis 6,
**dadurch gekennzeichnet,**
**dass** die Polymerisation und/oder Aerosolbildung bei Temperaturen zwischen -70°C und 155°C, bevorzugt zwischen -55°C und 150°C, durchgeführt wird.

8. Verfahren nach einem der Ansprüche 1 bis 7,
**dadurch gekennzeichnet,**
**dass** die Polymerisation mit einer Beschallungsdauer zwischen 1 Mikrosekunde und 15 Stunden, bevorzugt zwischen 0,05 und 12 Stunden, durchgeführt wird.

9. Verfahren nach einem der Ansprüche 1 bis 8,
**dadurch gekennzeichnet,**
**dass** das Verfahren in zwei Reaktionsbehältern durchgeführt wird, bei dem in einem Reaktionsbehälter die Polymerisation mittels akustischer Kavitation gemäß Schritt c) durchgeführt wird und in einem weiteren Reaktionsbehälter die Aerosolbildung mittels akustischer Kavitation und/oder Kapillarwellen durchgeführt wird.

10. Verfahren nach einem der Ansprüche 1 bis 8,
**dadurch gekennzeichnet,**
**dass** das Verfahren in einer Vorrichtung durchgeführt wird, bei dem in einem Reaktionsbehälter sowohl die Polymerisation mittels akustischer Kavitation gemäß Schritt c) durchgeführt wird als auch die Aerosolbildung mittels akustischer Kavitation und/oder Kapillarwellen durchgeführt wird.

11. Verfahren nach einem der Ansprüche 1 bis 10,
**dadurch gekennzeichnet,**
**dass** die Polymerisationsgeschwindigkeit (= Anstieg der molaren Masse (g/mol) pro Zeit), die Polymerisationsausbeute (= prozentualer Anteil der monomeren Hydridosilane, die zu höheren Hydridosilanen polymerisiert sind), Aerosolbildungsrate (= Volumen der erzeugten Aerosole pro Zeit), und der Aerosolfluss in Richtung Substrat (= Volumen der erzeugten Aerosole pro Zeit pro Fläche) durch die Konzentration der dazugegebenen Nanopartikel, die Restkonzentration der Edukte (= monomeren Hydridosilane), den Betriebsmodus (d.h. kontinuierlich oder gepulst), die Amplitude und Frequenz der Ultraschallquelle/des Schallwandlers, die die akustische Kavitation und/oder Kapillarwellen erzeugt, als auch über Abkühleinrichtungen eingestellt werden.

12. Verfahren nach einem der Ansprüche 1 bis 11,
**dadurch gekennzeichnet,**
**dass** das Substrat bei Verwendung von reinem flüssigem Hydridosilan mit gasförmigen Silanen und/oder flüssigen oder festen Hydridosilanen mit einer molaren Masse zwischen 32 und 1·10⁶ g/mol beschichtet wird und bei Verwendung einer Hydridosilanlösung das Substrat sowohl mit gasförmigen Silanen und/oder flüssigen oder festen Hydridosilanen als auch mit den gasförmigen Silanen und/oder Hydridosilane, die in Form von Lösungsmittel-Hydridosilan-Aerosoltröpfchen vorliegen, beschichtet wird.

13. Verfahren nach einem der Ansprüche 4 bis 12,
**dadurch gekennzeichnet,**
**dass** die Aerosoltröpfchen durch eine verschließbare Öffnung im Reaktionsbehälter gerichtet zur Substratoberfläche geleitet werden.

14. Verfahren nach einem der Ansprüche 1 bis 3 sowie 5 bis 11,
**dadurch gekennzeichnet,**
**dass** an Stelle der Umsetzung der Reaktionsprodukte aus Schritt c) in Aerosole, diese Reaktionsprodukte mit Hilfe von Rotationsbeschichtung und/oder Tauchbeschichtung und/oder Rakelbeschichtung und/oder Tintenstrahldruck mit der Oberfläche des Substrats gemäß Schritt d) in Kontakt gebracht werden.

15. Verfahren nach einem der Ansprüche 1 bis 14,
**dadurch gekennzeichnet,**
**dass** nach der Beschichtung eine Konvertierung in wasserstoffhaltiger und/oder Niederdruck-Atmosphäre durchgeführt wird.

16. Verfahren nach einem der Ansprüche 1 bis 15,
**dadurch gekennzeichnet,**
**dass** während der Polymerisation gemäß Schritt c) eine UV-Bestrahlung vorgenommen und/oder thermische Energie zugeführt wird.

17. Siliziumhaltige Schichten, hergestellt durch ein Verfahren nach einem der Ansprüche 1 bis 16, **dadurch gekennzeichnet, dass** sie Nanopartikel enthalten.

18. Verwendung der siliziumhaltigen Schichten nach Anspruch 17 zur Herstellung von halbleitenden oder isolierenden Dünnschichten mit darin eingebetteten Nanopartikeln.

## Claims

1. A method for the polymerization of a composition containing hydridosilanes and for the subsequent use of the polymers for producing layers containing silicon, comprising the steps of:
a) provision of a substrate.
b) provision of a composition containing at least one hydridosilane, which is either dissolved in at least one organic and/or inorganic solvent, or containing at least one hydridosilane, which is already present in liquid form without solvent, wherein the hydridosilanes comprise at least a linear and/or a branched hydridosilane of the general formula SiₙH₂ₙ+₂ with n ≥ 3 and/or a cyclic hydridosilane of the general formula SiₙH₂ₙ with n ≥ 3.
c) polymerization of the composition of step b) by acoustic cavitation.
d) coating the surface of the substrate with reaction products from step c).

2. The method according to claim 1, **characterized in that** the composition of step b) comprises , at least a lower hydridosilane with a molar mass between 90 and 305 g/mol, in particular from the group consisting of trisilane, tetrasilane, pentasilane, hexasilane, heptasilane, cyclopentasilane, cyclohexasilane, or neopentasilane.

3. The method according to any of claims 1 to 2, **characterized in that** at least mono- and/or disilane and/or a boron-containing dopant and/or a phosphorus-containing dopant and/or a noble gas from the group of Ar, He and/or nanoparticles and/or a polymerization initiator and/or a catalyst and/or surface tension-modifying agent is/are added to the hydridosilane solution or to the pure liquid hydridosilane.

4. The method according to any of claims 1 to 3, **characterized in that** the reaction products from step c) are converted into aerosols by means of acoustic cavitation and/or capillary waves, and these aerosols are brought into contact with the surface of the substrate for coating according to step d).

5. The method according to any of claims 1 to 4, **characterized in that** the acoustic cavitation is generated with the aid of a magnetostrictive or piezoelectric ultrasonic source and/or a liquid-operated or gas-operated sound transducer.

6. The method according to any of claims 1 to 5, **characterized in that** the ultrasound source and/or the sonic transducer for polymerization according to step c) and/or for reacting the reaction products from step c) to aerosols is brought into direct contact with the composition from step b) or c) or is brought into contact with the composition from step b) or c) via an intermedium.

7. The method according to any of claims 1 to 6, **characterized in that** the polymerization and/or aerosol formation is carried out at temperatures between -70 °C and 155 °C, preferably between -55 °C and 150 °C.

8. The method according to any of claims 1 to 7, **characterized in that** the polymerization is carried out with a sonication time between 1 microsecond and 15 hours, preferably between 0.05 and 12 hours.

9. The method according to any of claims 1 to 8, **characterized in that** the method is performed in two reaction vessels, in which the polymerization is performed in one reaction vessel by means of acoustic cavitation according to step c), and the aerosol formation is carried out in a further reaction vessel .by means of acoustic cavitation and/or capillary waves.

10. The method according to any of claims 1 to 8, **characterized in that** the method is performed in a device, in which both the polymerization by means of acoustic cavitation according to step c) and the aerosol formation by means of acoustic cavitation and/or capillary waves are performed in one reaction vessel.

11. The method according to any of claims 1 to 10, **characterized in that** that the polymerization rate (= increase in molar mass (g/mol) per time), the polymerization yield (= percentage of the monomeric hydridosilanes polymerized to higher hydridosilanes), the aerosol formation rate (= volume of the aerosols produced per time), and the aerosol flow in the direction of the substrate (= volume of the aerosols produced per time per area) are adjusted by the concentration of the nanoparticles added, the residual concentration of the reagents (= monomeric hydridosilanes), the operating mode (i.e., continuously or pulsed), the amplitude, and the frequency of the ultrasonic source/transducer generating the acoustic cavitation and/or capillary waves, and also via cooling apparatuses.

12. The method according to any of claims 1 to 11, **characterized in that**, when using pure liquid hydridosilane, the substrate is coated with gaseous silanes and/or liquid or solid hydridosilanes having a molar mass between 32 and 1·10⁶ g/mol and, when using a hydridosilane solution, the substrate is coated both with gaseous silanes and/or liquid or solid hydridosilanes and with the gaseous silanes and/or hydridosilanes, which are present in the form of solvent hydridosilane aerosol droplets.

13. The method according to any of claims 4 to 12, **characterized in that** the aerosol droplets are directed to the substrate surface through a closable opening in the reaction vessel.

14. The method according to any of claims 1 to 3 as well as 5 to 11, **characterized in that**, instead of reacting the reaction products from step c) to aerosols, such reaction products are brought into contact with the surface of the substrate according to step d) by means of rotary coating and/or dip coating and/or doctor blade coating and/or ink jet printing.

15. The method according to any of claims 1 to 14, **characterized in that**, after coating, a conversion into a hydrogen-containing and/or low-pressure atmosphere is performed.

16. The method according to any of claims 1 to 15, **characterized in that** UV irradiation is carried out and/or thermal energy is supplied during the polymerization according to step c) .

17. Layers containing silicon, produced by a method according to any one of claims 1 to 16, **characterized in that** they contain nanoparticles.

18. A use of the layers containing silicon according to claim 17 for producing semiconducting or insulating thin layers with nanoparticles embedded therein.

## Revendications

1. Procédé de polymérisation d'une composition contenant des hydrurosilanes et utilisation ensuite des polymérisats pour la production de couches contenant du silicium, comprenant les stades suivants :
a) on se procure un substrat.
b) on se procure une composition contenant au moins un hydrurosilane, qui ou bien est dissout dans au moins un solvant organique et/ou minéral ou bien contenant au moins un hydrurosilane, qui sans solvant est déjà liquide, dans lequel les hydrurosilanes comprennent au moins un hydrurosilane linéaire et/ou ramifié de formule brute SiₙH₂ₙ+₂ avec n ≥ 3 et/ou un hydrurosilane cyclique de formule brute SiₙH₂ₙ avec n ≥ 3.
c) on polymérise la composition du stade b) au moyen d'une cavitation acoustique.
d) on revêt la surface du substrat des produits de réaction du stade c).

2. Procédé suivant la revendication 1,
**caractérisé**
**en ce que** la composition du stade b) comprend au moins un hydrurosilane inférieur d'une masse molaire comprise entre 90 et 305 g/mol, en particulier du groupe trisilane, tétra silane, pentasilane, hexasilane, heptasilane, cyclopentasilane, cyclohexasilane ou néopentasilane.

3. Procédé suivant l'une des revendications précédentes,
**caractérisé**
**en ce que** l'on ajoute à la solution d'hydrurolisane ou à l'hydrurosilane liquide pur au moins un monosilane et/ou disilane et/ou une substance de dopage contenant du bore et/ou une substance de dopage contenant du phosphore et/ou un gaz rare du groupe Ar,He et/ou des nanoparticules et/ou un amorceur de polymérisation et/ou un catalyseur et/ou un agent modifiant la tension superficielle.

4. Procédé suivant l'une des revendications 1 à 3,
**caractérisé**
**en ce que** l'on transforme les produits de réaction du stade c) au moyen d'une cavitation acoustique et/ou d'ondes capillaires en des aérosols et on met ceux-ci pour le revêtement suivant le stade d) en contact avec la surface du substrat.

5. Procédé suivant l'une des revendications 1 à 4,
**caractérisé**
**en ce que** l'on crée la cavitation acoustique à l'aide d'une source d'ultrasons magnétostrictive ou piézoélectrique et/ou d'un transducteur acoustique à fonctionnement par du liquide ou à fonctionnement par du gaz.

6. Procédé suivant l'une des revendications 1 à 5,
**caractérisé**
**en ce que** l'on met la source d'ultrasons et/ou le transducteur acoustique, pour la polymérisation suivant le stade c) et/ou pour la transformation des produits de réaction du stade c) en aérosols, en contact direct avec la composition du stade b) ou c) ou on le met en contact par un intermédiaire avec la composition du stade b) ou c).

7. Procédé suivant l'une des revendications 1 à 6,
**caractérisé**
**en ce que** l'on effectue la polymérisation et/ou la formation d'un aérosol à des températures comprises -70°C et 155°C, de préférence entre -55°C et 150°C.

8. Procédé suivant l'une des revendications 1 à 7,
**caractérisé**
**en ce que** l'on effectue la polymérisation avec une durée de sonorisation comprise entre 1 microseconde et 15 heures, de préférence entre 0,05 et 12 heures.

9. Procédé suivant l'une des revendications 1 à 8,
**caractérisé**
**en ce que** l'on effectue le procédé dans des récipients de réaction, dans lequel, dans un récipient de réaction, on effectue la polymérisation au moyen d'une cavitation acoustique suivant le stade c) et, dans un autre récipient de réaction, on effectue la formation de l'aérosol au moyen d'une cavitation acoustique et/ou d'ondes capillaires.

10. Procédé suivant l'une des revendications 1 à 8,
**caractérisé**
**en ce que** l'on effectue le procédé dans un dispositif, dans lequel dans un récipient de réaction, on effectue tant la polymérisation au moyen d'une cavitation acoustique suivant le stade c) qu'également la formation de l'aérosol au moyen d'une cavitation acoustique et/ou d'onde capillaire.

11. Procédé suivant l'une des revendications 1 à 10,
**caractérisé**
**en ce que** l'on règle la vitesse de polymérisation (=augmentation de la masse molaire (g/mol) en fonction du temps), le rendement de polymérisation (= proportion en pourcentage des hydrurosilanes monomères, qui sont polymérisés en hydrurosilanes supérieurs), la vitesse de formation des aérosols (=volume des aérosols produits en fonction du temps) et le flux d'aérosols en direction du substrat (= volume des aérosols produits en fonction du temps par l'unité de surface) par la concentration des nanoparticules ajoutées, la concentration résiduelle des éduits (= hydrurosilanes monomères), le mode de fonctionnement (c'est-à-dire continu ou pulsé), l'amplitude et la fréquence de la source d'ultrasons/du transducteur acoustique, qui produit la cavitation acoustique et/ou des ondes capillaires, ainsi qu'également par des dispositifs de refroidissement.

12. Procédé suivant l'une des revendications 1 à 11,
**caractérisé**
**en ce que** l'on revêt le substrat en utilisant de l'hydrurosilane liquide pur avec des silanes gazeux et/ou des hydrurosilanes liquides ou solides d'une masse moléculaire comprise entre 32 à 1·10⁶ g/mol et, lorsque l'on utilise une solution d'hydrurosilane, on revêt le substrat tant par des silanes gazeux et/ou des hydrurosilanes liquides ou solides qu'également par des silanes gazeux et/ou des hydrurosilanes, qui se présentent sous la forme de gouttelettes d'aérosols de solvant - hydrurosilane.

13. Procédé suivant l'une des revendications 4 à 12,
**caractérisé**
**en ce que** l'on guide les gouttelettes d'aérosol par une ouverture pouvant être fermée du récipient de réaction dirigée vers la surface du substrat.

14. Procédé suivant l'une des revendications 1 à 3 ainsi que 5 à 11,
**caractérisé**
**en ce qu'**à l'endroit de la transformation des produits de réaction du stade c) en aérosols, on met ces produits de réaction en contact avec la surface du substrat suivant le stade d) à l'aide d'un revêtement par rotation et/ou d'un revêtement par immersion et/ou d'un revêtement à la racle et/ou d'une impression au jet d'encre.

15. Procédé suivant l'une des revendications 1 à 14,
**caractérisé**
**en ce qu'**après le revêtement, on effectue une conversion dans des atmosphères contenant de l'hydrogène et/ou sous basse pression.

16. Procédé suivant l'une des revendications 1 à 15,
**caractérisé**
**en ce que** pendant la polymérisation suivant le stade c) on expose a un rayonnement UV et/ou on apporte de l'énergie thermique.

17. Couches contenant du silicium, produites par un procédé suivant l'une des revendications 1 à 16, **caractérisées en ce qu'**elles contiennent des nanoparticules.

18. Utilisation des couches contenant du silicium suivant la revendication 17 pour la production de couches minces semiconductrices ou isolantes ayant des nanoparticules, qui y sont incorporées.
